(19) Europäisches Patentamt
European Patent Office
Office européen des brevets

(11) **EP 2 603 977 B1**

(12) **EUROPÄISCHE PATENTSCHRIFT**

(45) Veröffentlichungstag und Bekanntmachung des Hinweises auf die Patenterteilung:
**06.08.2014 Patentblatt 2014/32**

(51) Int Cl.:
*G01D 5/24* (2006.01)     *H03M 3/00* (2006.01)
*G01R 27/26* (2006.01)

(21) Anmeldenummer: **11743507.3**

(22) Anmeldetag: **05.08.2011**

(86) Internationale Anmeldenummer:
**PCT/EP2011/063568**

(87) Internationale Veröffentlichungsnummer:
**WO 2012/019976 (16.02.2012 Gazette 2012/07)**

(54) **KAPAZITÄTSMESSSCHALTUNG, SENSORSYSTEM UND VERFAHREN ZUM MESSEN EINER KAPAZITÄT UNTER VERWENDUNG EINES SINUSFÖRMIGEN SPANNUNGSSIGNALS**

CAPACITANCE MEASUREMENT CIRCUIT, SENSOR SYSTEM AND METHOD FOR MEASURING A CAPACITANCE USING A SINUSOIDAL VOLTAGE SIGNAL

CIRCUIT DE MESURE DE CAPACITÉ, SYSTÈME DÉTECTEUR ET PROCÉDÉ DE MESURE D'UNE CAPACITÉ AU MOYEN D'UN SIGNAL DE TENSION SINUSOÏDAL

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **12.08.2010 DE 102010039272**

(43) Veröffentlichungstag der Anmeldung:
**19.06.2013 Patentblatt 2013/25**

(73) Patentinhaber: **Fraunhofer Gesellschaft zur Förderung der angewandten Wissenschaft E.V. 80686 München (DE)**

(72) Erfinder:
• **MÖDL, Stefan**
  **91161 Hilpoltstein (DE)**
• **HAUER, Johann**
  **91058 Erlangen (DE)**
• **SAUERER, Josef**
  **91074 Herzogenaurach (DE)**

(74) Vertreter: **Burger, Markus et al Schoppe Zimmermann Stöckeler Zinkler & Partner Postfach 246 82043 Pullach (DE)**

(56) Entgegenhaltungen:
WO-A2-2006/098976     DE-A1-102005 038 875
US-B1- 6 452 521

• YUFENG DONG ET AL: "Force feedback linearization for higher-order electromechanical sigma-delta modulators; Force feedback linearization for higher-order electromechanical sigma--delta modulators", JOURNAL OF MICROMECHANICS & MICROENGINEERING, INSTITUTE OF PHYSICS PUBLISHING, BRISTOL, GB, Bd. 16, Nr. 6, 1. Juni 2006 (2006-06-01), Seiten S54-S60, XP020105018, ISSN: 0960-1317, DOI: 10.1088/0960-1317/16/6/S09
• CHONG ZHANG ET AL: "A large dynamic range CMOS readout circuit for MEMS vibratory gyroscope", 2008 IEEE SENSORS, LECCE, ITALY, IEEE, PISCATAWAY, NJ, USA, 26. Oktober 2008 (2008-10-26), Seiten 1123-1126, XP031375276, DOI: 10.1109/ICSENS. 2008.4716638 ISBN: 978-1-4244-2580-8

**EP 2 603 977 B1**

**Beschreibung**

Technisches Gebiet

Ausführungsbeispiele gemäß der Erfindung beziehen sich auf eine Kapazitätsmessschaltung. Weitere Ausführungsbeispiele gemäß der Erfindung beziehen sich auf ein Sensorsystem. Weitere Ausführungsbeispiele gemäß der Erfindung beziehen sich auf ein Verfahren zum Messen einer Kapazität.

Ausführungsbeispiele gemäß der Erfindung beziehen sich auf eine Messung von Kapazitäten mit Delta-Sigma-Modulatoren mit schmalbandiger Störabstrahlung.

Ausführungsbeispiele gemäß der Erfindung beziehen sich auf einen Kapazitäts-zu-digital-Konverter (CDC) (auch als "Kapazitiv-zu-digital-Konverter" bezeichnet) mit Sinus-Anregung.

Hintergrund der Erfindung

In vielen technischen Gebieten ist es wünschenswert, eine Größe einer Kapazität zu bestimmen. Beispielsweise existiert eine Vielzahl von verschiedenen Sensoren, bei denen eine zu erfassende technische bzw. physikalische Messgröße einen Einfluss auf den Wert einer Sensorkapazität hat. Somit ändert sich der Wert der Sensorkapazität in Abhängigkeit von der zu erfassenden technischen bzw. physikalischen Größe. In vielen Fällen ist es wünschenswert, eine digitale Information bereitzustellen, die den Wert der Sensorkapazität beschreibt, und die somit einen Rückschluss auf die zu messende technische bzw. physikalische Größe erlaubt.

Auch unabhängig von der Sensortechnik ist es in vielen Fällen wünschenswert, einen Wert einer Kapazität mit guter Genauigkeit zu bestimmen. Dies gilt beispielsweise für den Laborbereich, wo eine Kapazitätsmessung zum Abgleich von Baugruppen oftmals benötigt wird. Außerdem kann es beispielsweise von Bedeutung sein, den Wert einer Abstimmkapazität bzw. Anpasskapazität, die mit einer Antennenstruktur verbunden ist, zu ermitteln.

Zusammenfassend ist somit festzuhalten, dass kapazitive Sensoren in der Messtechnik und Sensorik in breitem Umfang eingesetzt werden, und dass eine Kapazitätsmessung auch ansonsten oftmals erforderlich ist.

Im Übrigen ist festzuhalten, dass es verschiedene Messverfahren zur Bestimmung von Kapazitätswerten gibt. Bekannte Messverfahren sind beispielsweise:

- Verstimmbare Oszillatoren, bei denen die Frequenz der Schwingung durch den kapazitiven Wert beeinflusst wird.

- Ladungsübertragungsverfahren (englisch: "Charge Transfer"), bei denen eine erste Kapazität in einer ersten Zeitphase aufgeladen und die Ladung in einer zweiten Phase in eine zweite Kapazität übertragen wird. Hierbei kann sowohl die erste Kapazität wie auch die zweite Kapazität als Messkapazität verwendet werden.

- Synchron-Demodulator-Verfahren: Die Amplitude einer Sinus- oder Rechteckschwingung wird durch die Kapazitätsänderung moduliert und mit einer Tiefpassfilterung in ein Messsignal umgewandelt.

- Einsatz von Standard-Sigma-Delta-Modulatoren mit gepulstem Ladungstransfer auf der Sensorelektronik: Betrieb eines Delta-Sigma-Modulators mit einer Referenzspannung am Eingang und Auswertung von Änderungen der Kapazität im Eingangszweig.

Sigma-Delta-Modulatoren werden für die Messung von Kapazitäten häufig eingesetzt. Im Folgenden wird kurz auf die Struktur und Funktionsweise herkömmlicher Delta-Sigma-Modulatoren eingegangen.

Diesbezüglich sei zunächst auf die DE 10 2005 038 875 A1 verwiesen, die eine Kapazitätsmessschaltung beschreibt. Die Kapazitätsmessschaltung umfasst einen Delta-Sigma-Modulator, der einen Operationsverstärker, einen ersten mit einem Eingang des Operationsverstärkers verbindbaren Kondensator und einen zweiten Kondensator in einem Rückkopplungszweig des Operationsverstärkers aufweist. Die Kapazitätsmessschaltung umfasst ferner eine Referenzsignalquelle, die mit dem ersten Kondensator verbindbar ist. Der erste oder der zweite Kondensator bilden dabei eine zu messende Kapazität. Bei der Kapazitätsmessschaltung wird nicht eine Eingangsgröße am Eingang des Delta-Sigma-Modulators gemessen und digitalisiert, sondern es wird stattdessen am Eingang eine definierte Referenzsignalquelle angeschlossen, und ein Bauteil des Delta-Sigma-Modulators selbst bildet die Messgröße. Ein Messergebnis wird dabei digital zur Verfügung gestellt.

Die WO 2006/098976 A2 beschreibt eine Schnittstellenschaltung für einen Kondensator mit einem Anschluss. Die Schnittstellenschaltung zur Erfassung der Kapazität des Kondensators umfasst einen differentiellen integrierenden Verstärker mit einer Eingangsgleichtaktspannung und zwei summierenden Knoten, deren Spannung im Wesentlichen gleich der Eingangsgleichtaktspannung ist. Die Schnittstelle umfasst ferner eine Schalter-Schaltung zum Laden des Kondensators auf einen ersten Spannungspegel in einer ersten Phase und zum Verbinden des Kondensators mit einem der summierenden Knoten des Differenzverstärkers in einer zweiten Phase. Dadurch wird eine erste Ausgangsveränderung bewirkt, die im Wesentlichen repräsentativ für den Unterschied zwischen dem ersten Spannungspegel und der Eingangsgleichtaktspannung ist, und die auch repräsentativ für den Kondensator ist. Die Schalter-Schaltung ist ferner ausgelegt, um den Kondensator in einer dritten Phase auf einen zweiten Spannungspegel zu laden, und um den Kondensator in einer vierten Phase mit dem anderen summierenden Knoten des Differenzverstärkers zu verbinden, um somit eine zweite Ausgangsveränderung bereitzustellen, die im Wesentlichen repräsentativ für die Differenz zwischen dem zweiten Spannungspegel und der Eingangsgleichtaktspannung ist, und die auch repräsentativ für den Kondensator ist. Die kombinierte erste und zweite Ausgangsveränderung stellen die Kapazität des Kondensators im Wesentlichen unabhängig von der Eingangsgleichtaktspannung dar.

Die Veröffentlichung "Force feedback linearization for higher-order electromechanical sigma-delta modulators" von Y. Dong u.a. (veröffentlicht in: Journal of Micromechanics and Microengineering, Institute of Physics Publishing, Bristol, Great Britain, Bd. 16, Nr. 6, 1. Juni 2006, S54-S60) beschreibt einen elektromechanischen Sigma-Delta-Modulator höherer Ordnung, der im Vergleich zu einer Schleife zweiter Ordnung ein besseres Signal-zu-Rausch-Verhältnis mit sich bringt. Es wird eine Strategie zur Kraft-Rückkopplungs-Linearisierung beschrieben, die sich positiv auf das Signal-zu-Rausch-Verhältnis und das Verzerrungs-Verhältnis auswirkt.

Die Veröffentlichung "A large dynamic range CMOS Readout Circuit for MEMS Vibratory Gyroscope" von C. Zhang u.a. (veröffentlicht auf der IEEE Sensors 2008 Conference, Lecce, Italien, IEEE, Piscataway, New Jersey, USA, 26. Oktober 2008, Seiten 1123-1126) beschreibt eine integrierte Schaltung zum Auslesen eines mikromaschinell hergestellten Vibrations-Gyroskops. Es wird eine sinusförmige Chopper-Technik und eine Dual-Operationsverstärkerstruktur beschrieben. Unter anderem findet ein Biasing der Hochimpedanz-Knoten in einer traditionellen voll-differentiellen Schaltung statt. Ferner erfolgt eine Kapazitäts-Spannungs-Wandlung mit hoher Linearität.

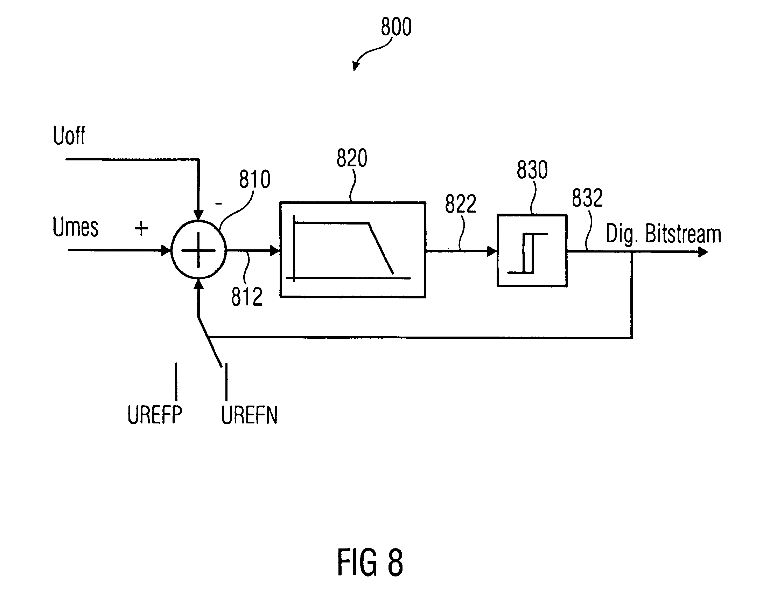

Im Folgenden wird das Prinzip eines Delta-Sigma-Modulators kurz anhand der Fig. 8 beschrieben. Fig. 8 zeigt ein Blockschaltbild eines Delta-Sigma-Modulators. Der Delta-Sigma-Modulator 800 gemäß Fig. 8 umfasst einen eingangsseitigen Summierer 810, der ausgelegt ist, um eine Messgröße Umes, eine schaltbare Referenzgröße UREFP bzw. UREFN sowie, optional, eine Offsetgröße Uoff zu empfangen und die empfangenen Größen mit entsprechendem Vorzeichen zu summieren. Die Offsetgröße Uoff kann dabei beispielsweise mit negativem Vorzeichen eingehen und die Messgröße Umes beispielsweise zumindest teilweise kompensieren. An einem Ausgang des Summierers 810 liegt somit eine Größe 812 an, die einem Ergebnis einer (gegebenenfalls vorzeichenbehaftete) Summation der Messgröße Umes, der Offsetgröße Uoff und der jeweiligen Referenzgröße UREFP bzw. UREFN entspricht.

Der Delta-Sigma-Modulator 800 umfasst ferner einen Integrator 820, der ausgelegt ist, um die Summengröße 812 zu empfangen und zu integrieren, um somit ein Integrator-Ausgangssignal 822 zu erhalten.

Der Delta-Sigma-Modulator 800 umfasst ferner einen Schwellwert-Entscheider 830, der ausgelegt ist, um das Integrator-Ausgangssignal bzw. Integrator-Ergebnissignal 822 zu empfangen und mit einem Schwellwert zu vergleichen, um somit ein wertdiskretes (z. B. binäres) Ausgangssignal 832 zu erhalten, das ein Ergebnis des Vergleichs darstellt. Das Ausgangssignal 832 ist bevorzugt auch zeitdiskret und stellt somit einen digitalen Bitstrom dar. Das Ausgangssignal 832 bzw. der entsprechende digitale Bitstrom wird im Übrigen verwendet, um zu entscheiden, ob dem Summierer 810 eine erste Referenzgröße UREFP oder eine zweite Referenzgröße UREFN zugeführt wird. Somit entscheidet das Ausgangssignal 832 des Schwellwert-Entscheiders typischerweise, ob das Ausgangssignal 812 des Summierers 810 eine Aufwärts-Integration oder eine Abwärts-Integration des Integrators 820 bewirkt.

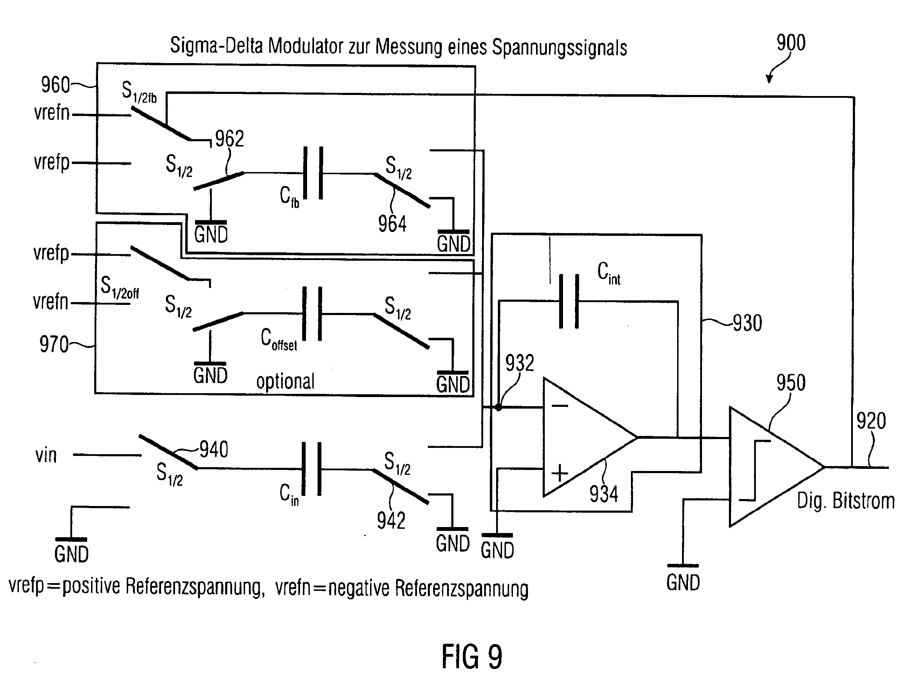

Im Folgenden wird Bezug nehmend auf die Fig. 9 ein herkömmlicher Delta-Sigma-Modulator zur Messung eines Spannungssignal etwas detaillierter beschrieben. Ein leicht vereinfachtes Schaltbild eines derartigen Sigma-Delta-Modulators 900 ist in der Fig. 9 gezeigt.

Der Sigma-Delta-Modulator 900 empfängt eine Eingangsspannung vin und liefert, basierend darauf, einen digitalen Bitstrom 920, der die Eingangsspannung vin (beispielsweise bezogen auf ein Bezugspotential GND) beschreibt. Der Sigma-Delta-Modulator 900 umfasst, als ein zentrales Element, einen Integrator 930, der ausgelegt ist, um eine elektrische Ladung aufzuintegrieren. Zu diesem Zweck umfasst der Integrator 930 einen Operationsverstärker 934 sowie eine Integrationskapazität Cint. Ein nicht-invertierender Eingang (+) ist beispielsweise mit dem Bezugspotential GND gekoppelt. Die Integrationskapazität Cint ist beispielsweise zwischen den invertierenden Eingang (-) und den Ausgang des Operationsverstärkers 932 geschaltet. Ein Knoten an dem invertierenden Eingang (-) des Operationsverstärkers 932 dient somit als Ladungs-Summationsknoten, da eine in diesen Ladungs-Summationsknoten 932 hineinfließende Ladung auf die Integrationskapazität Cint aufintegriert wird. Diesbezüglich sei im Übrigen festzuhalten, dass der Ladungs-Summationsknoten 932 einen Virtuelle-Masse-Knoten darstellt, da ja der Operationsverstärker 932 - von parasitären Offsetspannungen abgesehen - zumindest näherungsweise bewirkt, dass der Ladungs-Summationsknoten 932 sich auf dem gleichen Potential befindet wie der nicht-invertierende Eingang (+), also beispielsweise auf dem Bezugspotential. Im Übrigen kann im Regelfall davon ausgegangen werden, dass eine in den invertierenden Operationsverstärker-Eingang hineinfließende Ladung vernachlässigbar klein ist, da die Eingänge des Operationsverstärkers 934 typischerweise sehr hochohmig sind.

Der Sigma-Delta-Modulator 900 weist ferner eine Eingangskapazität Cin auf, deren erster Anschluss über einen Umschalter 940 in einer ersten Phase mit der Eingangsspannung vin und in einer zweiten Phase mit dem Bezugspotential GND verbindbar ist. Ein zweiter Anschluss der Eingangskapazität Cin ist im Übrigen über einen Schalter 942 in einer ersten Phase mit dem Bezugspotential GND verbindbar und in einer zweiten Phase mit dem Ladungs-Summationsknoten 932. Somit wird die Eingangskapazität Cin in der ersten Phase (Schalterstellung der Schalter 940, 942 wie in der Fig. 9 gezeigt) aufgeladen, wobei eine auf die Eingangskapazität Cin aufgebrachte Ladung von der Größe der Eingangsspannung vin (bezogen auf das Bezugspotential) und der Größe der Kapazität Cin abhängig ist, wobei hier gilt Qin = Cin * vin. In der zweiten Phase, in der die Schalterstellungen der Schalter 940, 942 entgegengesetzt zu den in der Fig. 9 gezeigten Schalterstellungen sind, wird die Eingangskapazität Cin entladen, wobei die in der ersten Phase auf die Kapazität Cin aufgebrachte Ladung der Integrationskapazität Cint zugeführt wird, soweit und sofern diese nicht durch Ladung von der Rückkopplungskapazität Cfb und/oder von der Offset-Kapazität Coffset kompensiert wird.

Der Sigma-Delta-Modulator umfasst im Übrigen einen Rückkopplungszweig. Der Rückkopplungszweig umfasst im Wesentlichen einen Schwellwertvergleicher 950. Der Schwellwertvergleicher 950 ist beispielsweise ausgelegt, um die Spannung an dem Ausgang des Operationsverstärkers 934 mit dem Bezugspotential zu vergleichen und abhängig von einem Ergebnis des Vergleichs an seinem Ausgang einen ersten digitalen Wert oder einen zweiten digitalen Wert zu liefern. Der erste digitale Wert (z. B. logisch "0") bzw. der zweite digitale Wert (z. B. logisch "1") bildet dabei ein Bit des digitalen Bitstroms 920. Der Sigma-Delta-Modulator umfasst ferner einen Rückkopplungs-Ladungsbereitsteller 960, der ausgelegt ist, um in Abhängigkeit von dem digitalen Wert an dem Ausgang des Schwellwertvergleichers 950 in einem Zyklus des Sigma-Delta-Modulators eine positive Ladung einer vorbestimmten Ladungsmenge oder eine negative Ladung einer vorbestimmten Ladungsmenge zu dem Ladungs-Summationsknoten 932 zuzuführen. Zu diesem Zweck wird die Rückkopplungskapazität Cfb beispielsweise in einer ersten Phase über einen ersten Schalter 962 und einen zweiten Schalter 964 entladen. In einer zweiten Phase wird ein erster Anschluss der Rückkopplungskapazität Cfb wahlweise, in Abhängigkeit davon, ob der Ausgang des Schwellwertvergleichers 950 einen ersten logischen Pegel oder einen zweiten logischen Pegel annimmt, mit einer positiven Referenzspannung vrefp oder einer negativen Referenzspannung vrefn verbunden. Gleichzeitig wird ein zweiter Anschluss der Rückkopplungskapazität Cfb in der zweiten Phase mit dem Ladungs-Summationsknoten 932 gekoppelt. Dementsprechend wird unter Verwendung der Rückkopplungskapazität Cfb eine Rückkopplungsladung Qfb = Cfb * vrefp bzw. eine Ladung Qfb = Cfb * vrefn an den Summationsknoten 932 geliefert, je nachdem, ob der Ausgang des Schwellwertvergleichers 950 in dem betreffenden Zyklus des Delta-Sigma-Modulators einen ersten logischen Wert oder einen zweiten logischen Wert annimmt.

Optional kann während eines Zyklus des Sigma-Delta-Modulators zusätzlich noch eine Offsetladung unter Verwendung einer Offset-Ladungs-Bereitstellungsschaltung 970 zu dem Ladungs-Summationsknoten 932 zugeführt, um beispielsweise einen Offsetwert des Sigma-Delta-Modulators einzustellen.

Insgesamt wird somit ein digitaler Bitstrom 920 erzeugt, der (durch Ansteuerung der Offset-Ladungs-Bereitstellungsschaltung 960) bewirkt, dass die über die Eingangskapazität Cin zu dem Ladungs-Summationsknoten 932 zugeführte Ladung im Wesentlichen durch die Summe aus der durch die Rückkopplungs-Ladungsbereitstellungsschaltung 960 und (optional) durch die Offset-Ladungsbereitstellungsschaltung 970 zu dem Ladungs-Summationsknoten 932 zugeführte Ladung kompensiert wird. Der digitale Bitstrom gibt somit für eine Folge von Zyklen des Sigma-Delta-Modulators an, ob eine positive Rückkopplungsladung oder eine negative Rückkopplungsladung zu dem Ladungs-Summationsknoten 932 zugeführt werden muss, um den Pegel an dem Ausgang des Operationsverstärkers 932 hin zu dem Schwellwert des Schwellwertvergleichers 950 zu verringern. Somit ist der digitale Bistrom 920 ein Maß für eine in einem Zyklus des Sigma-Delta-Modulators zu dem Ladungs-Summationsknoten 932 zugeführte Ladung Qin, welche wiederum ein Produkt aus der Eingangsspannung vin und der Eingangskapazität Cin ist.

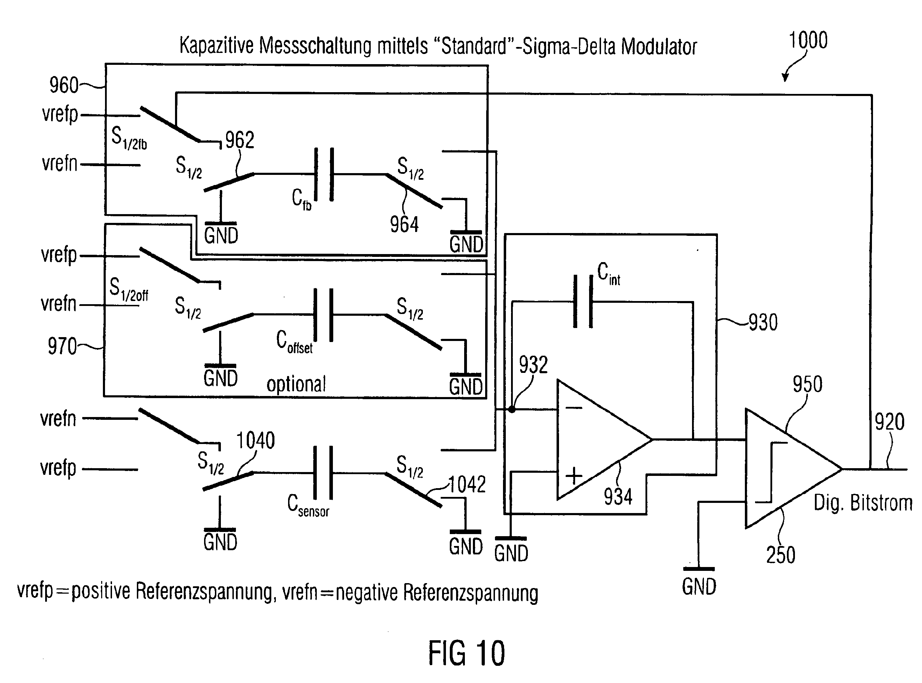

Im Folgenden wird Bezug nehmend auf die Fig. 10 eine Kapazitätsmessschaltung (auch als "kapazitive Messschaltung" bezeichnet) 1000 mittels eines "Standard"-Sigma-Delta-Modulators beschrieben. Diese Schaltung unterscheidet sich von dem Sigma-Delta-Modulator 900 gemäß der Fig. 9, der zur Messung eines Spannungssignals dient, nur geringfügig, so dass hier nur auf die Unterschiede eingegangen wird. Im Übrigen sind gleiche bzw. gleich wirkende Einrichtungen mit gleichen Bezugszeichen versehen und werden hier nicht noch einmal erläutert.

Die Messschaltung 1000 unterscheidet sich von der Messschaltung 900 gemäß Fig. 9 dadurch, wie die Eingangsladung zu dem Ladungs-Summationsknoten 932 zugeführt wird. Die Kapazitätsmessschaltung 1000 umfasst hierbei eine zu messende Kapazität bzw. Sensorkapazität Csensor, die in einer ersten Phase unter Verwendung von Schaltern 1040, 1042 entladen wird. Die zu messende Kapazität bzw. Sensorkapazität Csensor wird ferner in einer zweiten Phase über die Schalter 1040, 1042 zwischen ein vorgegebenes, typischerweise zeitlich konstantes, Referenzpotential vrefn bzw. Referenzpotential vrefp und den Ladungs-Summationsknoten 932 geschaltet, so dass dem Ladungs-Summationsknoten hier in einem Zyklus der Kapazitätsmessschaltung eine Ladung Qsensor = vrefn * Csensor bzw. Qsensor = vrefp * Csensor zugeführt wird. Die aufgrund der zu messenden Kapazität bzw. Sensorkapazität Csensor dem Ladungs-Summationsknoten 932 zugeführte Ladung ist somit aufgrund der Tatsache, dass die Spannung vrefn bzw. vrefp vorgegeben und bekannt ist, ein Maß für die unbekannte bzw. zu messende Kapazität Csensor. Diese aufgrund der zu messenden Kapazität bzw. Sensorkapazität Csensor aufgebrachte Ladung Qsensor wird durch den Sigma-Delta-Wandler bestimmt, so dass der digitale Bitstrom 920 die Ladung Qsensor beschreibt und damit auch die Kapazität Csensor beschreibt.

Wenngleich Sigma-Delta-Modulatoren häufig für die Messung von Kapazitäten eingesetzt werden, wie dies beispielsweise anhand der Fig. 10 beschrieben wurde, so wurde doch herausgefunden, dass es jedoch aufgrund der gepulsten Umladung der Sensorkapazität (z. B. der Kapazität Csensor gemäß der Fig. 10) bei einigen Anwendungen Probleme mit der breitbandigen Störabstrahlung gibt.

Es wurde herausgefunden, dass dies beispielsweise dann der Fall ist, wenn dieses Verfahren (z. B. das anhand der Fig. 10 beschriebene Verfahren) zur Überwachung von elektrisch angetriebenen Fenstern und Türen beim Schließvorgang gegen unbeabsichtigtes Einklemmen von Personen und Objekten angewendet wird.

Es wurde herausgefunden, dass es hier durch die antennenähnliche Struktur der Sensorkapazität zu einer breitbandigen Abstrahlung von elektromagnetischen Wellen durch die gepulsten Umladeströme, verursacht durch die nahezu rechteckförmig gepulste Ansteuerung der Sensorkapazität, kommt.

Ferner wurde erkannt dass dies bei verschiedenen Anwendungen zu einer Überschreitung von Grenzwerten bezüglich der elektromagnetischen Verträglichkeit führt. So kann es beim Einsatz in der Automobilindustrie zu einer hörbaren Störung im Radioempfang kommen, die kaum zu vermeiden ist, da das abgestrahlte Spektralband bis in den Gigahertz-Bereich nachweisbar ist.

Um die genannten Probleme im Hinblick auf die elektromagnetische Verträglichkeit zu verringern bzw. zu vermeiden, werden herkömmlicherweise schmalbandige Messverfahren eingesetzt. Solche schmalbandigen Messverfahren verwenden häufig Synchrondemodulatoren oder eingerastete Verstärker (auch als "Lock-In"-Verstärker bezeichnet). Damit wird die Störabstrahlung auf ein schmales Band begrenzt. Diese Verfahren haben jedoch deutliche Nachteile bei Offsetkompensation, Verstärkungseinstellung und Messfrequenzumschaltung.

In Anbetracht dessen ist es die Aufgabe der vorliegenden Erfindung, ein Konzept zur Kapazitätsmessung zu schaffen, das einen verbesserten Kompromiss im Hinblick auf eine Genauigkeit der Kapazitätsmessung und eine Störabstrahlung liefert.

<u>Zusammenfassung der Erfindung</u>

Diese Aufgabe wird durch eine anspruchsgemäße Kapazitätsmessschaltung, ein anspruchsgemäßes Sensorsystem und ein anspruchsgemäßes Verfahren zur Messung einer Kapazität gelöst.

Ein Ausführungsbeispiel gemäß der Erfindung schafft eine Kapazitätsmessschaltung mit einer Messspannungsquelle, die ausgelegt ist, um einem ersten Anschluss einer zu messenden Kapazität ein - zumindest näherungsweise - sinusförmiges Spannungssignal zuzuführen, um eine zeitliche Änderung einer in der zu messenden Kapazität gespeicherten Ladung zu bewirken. Die Kapazitätsmessschaltung umfasst ferner einen Delta-Sigma-Modulator. Der Delta-Sigma-Modulator ist ausgelegt, um von einem zweiten Anschluss der zu messenden Kapazität eine Ladung zu erhalten und ein digitales Ausgangssignal bereitzustellen, das von einer Größe der von der zu messenden Kapazität erhaltenen Ladung abhängig ist.

Dieses Ausführungsbeispiel gemäß der Erfindung basiert auf der Erkenntnis, dass eine zuverlässige Messung einer Kapazität unter Verwendung eines Delta-Sigma-Modulators auch dann möglich ist, wenn an einem ersten Anschluss der zu messenden Kapazität statt des herkömmlicherweise verwendeten rechteckförmigen Signals ein - zumindest näherungsweise - sinusförmiges Signal angelegt wird, wobei die Verwendung eines zumindest näherungsweise sinusförmigen Signals den wesentlichen Vorteil mit sich bringt, dass eine Störabstrahlung durch eine Elektrode der Sensorkapazität (sowie durch gegebenenfalls vorhandene entsprechende Zuführungsleitungen) nur sehr schmalbandig ist. Dadurch verbessert sich bei der erfindungsgemäßen Schaltung die elektromagnetische Verträglichkeit im Vergleich zu herkömmlichen Schaltungen, bei denen ein näherungsweise rechteckförmiges Signal an einem Anschluss der zu messenden Kapazität anliegt, ganz erheblich, ohne dass die Präzision der Kapazitätsmessung durch die Verwendung eines zumindest näherungsweise sinusförmigen Signals wesentlich verschlechtert wird.

Die erfindungsgemäße Kapazitätsmessschaltung bringt somit erhebliche Vorteile, da an dem ersten Anschluss der Kapazität ein im Wesentlichen sinusförmiges Spannungssignal anliegt, was zu einer schmalbandigen und damit vergleichsweise "harmlosen", weil gut ausfilterbaren, Störabstrahlung führt. Im Übrigen kann durch eine Übertragung einer Ladung von der zu messenden Kapazität zu dem Delta-Sigma-Modulator ein Kapazitätswert der zu messenden Kapazität mit hoher Genauigkeit bestimmt werden. Messfehler sind aufgrund der Verwendung eines Delta-Sigma-Modulators zur Bestimmung des Kapazitätswerts typischerweise geringer als beim Einsatz eines Synchron-Demodulators oder eines eingerasteten Verstärkers.

Bei einem bevorzugten Ausführungsbeispiel ist die Kapazitätsmessschaltung ausgelegt, um die zu messenden Kapazität in einer ersten Phase unter Verwendung des sinusförmigen Spannungssignals in einen ersten Aufladungszustand zu bringen, und um die zu messende Kapazität in einer zweiten Phase unter Verwendung des sinusförmigen Spannungssignals in einen zweiten Aufladungszustand zu bringen. Der Delta-Sigma-Modulator ist in diesem Fall ausgelegt, um eine Ladungsmenge, die gleich einem Unterschied zwischen einer auf der zu messenden Kapazität in dem ersten Aufladungszustand gespeicherten Ladungsmenge und einer auf der zu messenden Kapazität in dem zweiten Aufladungszustand gespeicherten Ladungsmenge ist, zu empfangen und das digitale Ausgangssignal in Abhängigkeit von der empfangenen Ladungsmenge bereitzustellen. Es wurde herausgefunden, dass sich auch ein zumindest näherungsweise sinusförmiges Spannungssignal sehr gut dazu eignet, die zu messende Kapazität in zwei wohl-definierte Aufladungszustände zu versetzen, so dass ein Unterschied zwischen den auf der zu messenden Kapazität gespeicherten Ladungsmengen ein präzises Maß für einen Kapazitätswert der zu messenden Kapazität ist und durch den Delta-Sigma-Modulator auswertbar ist.

Bei einem bevorzugten Ausführungsbeispiel weist der Delta-Sigma-Modulator eine Integrationskapazität auf. In diesem Fall ist der Delta-Sigma-Modulator ausgelegt, um den zweiten Anschluss der zu messenden Kapazität in der ersten Phase von der Integrationskapazität zu trennen und um den zweiten Anschluss der zu messenden Kapazität in der zweiten Phase mit der Integrationskapazität zu koppeln. Somit wird die Ladung auf der Integrationskapazität in der zweiten Phase durch eine Veränderung der auf der zu messenden Kapazität gespeicherten Ladung verändert bzw. beeinflusst. Dies ermöglicht eine präzise Bestimmung des Kapazitätswerts, da die von der zu messenden Kapazität auf die Integrationskapazität übertragene Ladungsmenge im Wesentlichen proportional zu einem Produkt aus dem Kapazitätswert der zu messenden Kapazität und der Spannungsdifferenz an dem ersten Anschluss der Kapazität zwischen dem Ende der ersten Phase und dem Ende der zweiten Phase ist. Letztere Spannungsänderung ist typischerweise mit hoher Präzision bestimmbar bzw. festgelegt.

Bei einem bevorzugten Ausführungsbeispiel ist der Delta-Sigma-Modulator ausgelegt, um den zweiten Anschluss der zu messenden Kapazität, von kurzen (parasitären und nicht zwingend erforderlichen) Übergangsphasen, während derer der zweite Anschluss der zu messenden Kapazität in einem elektrisch schwebenden Zustand ist, abgesehen, auf ein vorgegebenes konstantes Potential zu ziehen. Indem ein näherungsweise konstantes zweites Potential (bezogen auf ein Bezugspotential) an dem zweiten Anschluss der zu messenden Kapazität eingestellt bzw. angelegt wird, werden Störabstrahlungen durch die zweite Elektrode der zu messenden Kapazität im Wesentlichen vermieden. Somit liegt an der ersten Elektrode der zu messenden Kapazität typischerweise ein näherungsweise sinusförmiger Spannungsverlauf an, während hingegen an der zweiten Elektrode der zu messenden Kapazität eine konstante Spannung (bzw. ein konstantes Potential) anliegt. Somit geht nur eine geringe und im Wesentlichen schmalbandige Störabstrahlung von der zu messenden Kapazität aus, was insbesondere in Fällen, in denen die zu messende Kapazität räumlich groß ist und somit eine ausgeprägte Abstrahlneigung aufweist, von besonderem Vorteil ist.

Bei einem bevorzugten Ausführungsbeispiel ist die Messspannungsquelle ausgelegt, um während einer Kapazitätsmessung der zu messenden Kapazität ein frequenzstabiles und amplitudenstabiles sinusförmiges Spannungssignal zuzuführen. Ein über eine Vielzahl von drei oder sogar mehr Perioden (beispielsweise zumindest 20 Perioden oder zumindest 100 Perioden oder sogar zumindest 1.000 Perioden) frequenzstabiles (zum Beispiel innerhalb einer Frequenztoleranz von beispielsweise +/- 5 % oder sogar +/- 1 %) und amplitudenstabiles (zum Beispiel innerhalb einer Toleranz von +/- 10 % oder sogar von +/- 2 %) sinusförmiges Spannungssignal weist ein vergleichsweise schmales Spektrum auf und bringt somit nur schmalbandige Störungen mit sich.

Bei einem bevorzugten Ausführungsbeispiel ist die Messspannungsquelle somit ausgelegt, um das frequenzstabile und amplitudenstabile sinusförmige Spannungssignal zumindest drei Perioden lang ununterbrochen dem ersten Anschluss der zu messenden Kapazität zuzuführen.

Bei einem bevorzugten Ausführungsbeispiel ist die Kapazitätsmessschaltung ausgelegt, um an der zu messenden Kapazität einen periodischen Spannungsverlauf zu erzeugen, so dass sich Spannungswerte über der zu messenden Kapazität von Spannungswerten eines sinusförmigen Spannungsverlaufs während einer Periode um höchstens 10 %, bezogen auf eine Amplitude des sinusförmigen Spannungsverlaufs, unterscheiden. Dadurch wird wiederum sichergestellt, dass eine Störabstrahlung durch die zu messende Kapazität gering gehalten wird.

Bei einem bevorzugten Ausführungsbeispiel ist der Delta-Sigma-Modulator ausgelegt, um den zweiten Anschluss der zu messenden Kapazität in der ersten Phase mit einer Bezugspotentialzuführung zu verbinden und um den zweiten Anschluss der zu messenden Kapazität in der zweiten Phase mit einem Virtuelle-Masse-Knoten zu verbinden, und um eine auf der zu messenden Kapazität gespeicherte Ladung während der zweiten Phase zu erfassen. Durch eine entsprechende Vorgehensweise ist es möglich, die zu messende Kapazität in der ersten Phase in einen ersten Aufladungszustand zu versetzen, ohne dass dadurch eine in der Integrationskapazität des Delta-Sigma-Modulators gespeicherte Ladungsmenge verändert wird. Während der zweiten Phase hingegen wird die in der zu messenden Kapazität gespeicherte Ladung verändert, da sich typischerweise die an dem ersten Anschluss der zu messenden Kapazität zu dem Ende der zweiten Phase anliegende Spannung von der am Ende der ersten Phase an dem ersten Anschluss der zu messenden Kapazität anliegenden Spannung unterscheidet. Die durch diese Spannungsveränderung hervorgerufene Ladungsveränderung wird durch den Delta-Sigma-Modulator erfasst und trägt (typischerweise in Verbindung mit einer durch eine Rückkopplungskapazität bereitgestellten Ladung und einer durch eine Offset-Kapazität bereitgestellten Ladung) zu einer Veränderung der auf der Integrationskapazität des Delta-Sigma-Modulators gespeicherten Ladungsmenge bei.

Bei einem bevorzugten Ausführungsbeispiel ist die Kapazitätsmessschaltung so ausgelegt, dass das von der Messspannungsquelle bereitgestellte näherungsweise sinusförmige Spannungssignal mit Arbeitsphasen des Delta-Sigma-Modulators synchronisiert ist. Durch die entsprechende Synchronisation wird sichergestellt, dass sich aufgrund des an dem ersten Anschluss der zu messenden Kapazität angelegten sinusförmigen Spannungssignals während der Arbeitsphasen des Delta-Sigma-Modulators bzw. zwischen den Arbeitsphasen des Delta-Sigma-Modulators eine wohl definierte Ladungsänderung ergibt, die ein Maß für einen Kapazitätswert der zu messenden Kapazität ist.

Bei einem bevorzugten Ausführungsbeispiel ist der Delta-Sigma-Modulator ausgelegt, um einen Übergang zwischen einer ersten Phase, während der der zweite Anschluss der zu messenden Kapazität von einer Integrationskapazität des Delta-Sigma-Modulators getrennt ist, und einer zweiten Phase, während der der zweite Anschluss der zu messenden Kapazität mit der Integrationskapazität gekoppelt ist, zumindest näherungsweise (z. B. innerhalb einer Toleranz von +/- 10 % oder +/- 5 % einer Periodendauer) zur Zeit eines Maximums des (zumindest näherungsweise) sinusförmigen Spannungssignals oder zur Zeit eines Minimums des (zumindest näherungsweise) sinusförmigen Spannungssignals vorzunehmen. Eine derartige Einstellung der zeitlichen Abläufe führt dazu, dass das Umschalten zwischen der ersten Phase und der zweiten Phase zu einem Zeitpunkt geschieht, zu dem sich die an dem ersten Anschluss der zu messenden Kapazität anliegende Spannung nur geringfügig über der Zeit ändert. Somit ist der Zeitpunkt des Umschaltens zwischen der ersten Phase und der zweiten Phase wenig kritisch und verfälscht kaum das Messergebnis. Außerdem kommt es bei einer derartigen Wahl des Umschaltzeitpunkts typischerweise nicht zu signifikanten Störungen der Spannung auf der zweiten Elektrode der zu messenden Kapazität, was wiederum in geringer Störabstrahlung resultiert.

Bei einem bevorzugten Ausführungsbeispiel weist der Delta-Sigma-Modulator einen Ladungsintegrator mit einem eingangsseitigen Ladungs-Summationsknoten und einem Integrationsergebnisausgang auf. Der Ladungsintegrator ist dabei ausgelegt, um eine an dem eingangsseitigen Ladungs-Summationsknoten empfangene Ladung aufzuintegrieren, um das Signal an dem Integrationsergebnisausgang zu erhalten. Der Delta-Sigma-Modulator weist ferner einen Schwellwertvergleicher auf, der ausgelegt ist, um einen an dem Integrationsergebnisausgang des Ladungsintegrators anliegenden Pegel, der ein Integral der an dem Ladungs-Summationsknoten empfangenen Ladung beschreibt, mit einem Schwellwert zu vergleichen und abhängig von einem Ergebnis des Vergleichs einen diskreten Wert bereitzustellen. Der Delta-Sigma-Modulator ist ferner ausgelegt, um an dem Ladungs-Summationsknoten eine Ladung von dem zweiten Anschluss der zu messenden Kapazität zu empfangen und zusätzlich eine von dem Ergebnis des Vergleichs abhängige Ladungsmenge zu dem Ladungs-Summationsknoten zuzuführen. Somit verwirklicht der Delta-Sigma-Modulator das Prinzip, die von der zu messenden Kapazität gelieferte Ladungsmenge durch eine rückgekoppelte Ladungsmengen-Kompensation zu bestimmen, wobei ein wertdiskretes Signal erhalten wird.

Bei einem bevorzugten Ausführungsbeispiel ist der Delta-Sigma-Modulator somit ausgelegt, um dem Ladungs-Summationsknoten in einer Phase des Delta-Sigma-Modulators (die beispielsweise ein Teil eines Arbeitszyklus ist) eine vorbestimmte Ladungsmenge zuzuführen, die eine von der zu messenden Kapazität empfangene Ladungsmenge zumindest teilweise kompensiert.

Bei einem weiteren bevorzugten Ausführungsbeispiel umfasst der Delta-Sigma-Modulator eine Offset-Kapazität mit einem ersten Anschluss und einem zweiten Anschluss. Der Delta-Sigma-Modulator ist in diesem Fall ausgelegt, um an den ersten Anschluss der Offset-Kapazität ein (zumindest näherungsweise) sinusförmiges Spannungssignal anzulegen, und um den zweiten Anschluss der Offset-Kapazität zyklisch mit dem Ladungs-Summationsknoten zu koppeln und von dem Ladungs-Summationsknoten zu trennen. Auf diese Weise liegt auf der ersten Elektrode der Offset-Kapazität ein zumindest näherungsweise sinusförmiges Spannungssignal an, was wiederum der Vermeidung breitbandiger Störungen sehr zuträglich ist. Im Übrigen kann durch das zyklische Koppeln des zweiten Anschlusses der Offset-Kapazität mit dem Ladungs-Summationsknoten dem Ladungs-Summationsknoten eine wohl definierte Ladungsmenge zugeführt werden, die zu einer zumindest teilweisen Kompensation der von der zu messenden Kapazität empfangenen Ladung beiträgt bzw. sogar eine Überkompensation der von der zu messenden Kapazität empfangenen Ladung bewirkt.

Bei einem bevorzugten Ausführungsbeispiel ist der Delta-Sigma-Modulator ausgelegt, um an dem ersten Anschluss der Offset-Kapazität ein zumindest näherungsweise sinusförmiges Spannungssignal anzulegen, das gegenphasig zu dem von der Messspannungsquelle bereitgestellten näherungsweise sinusförmigen Spannungssignal ist. Der Delta-Sigma-Modulator ist dabei ausgelegt, um den zweiten Anschluss der Offset-Kapazität und den zweiten Anschluss der zu messenden Kapazität während der gleichen Zeitintervalle mit dem Ladungs-Summationsknoten zu verbinden. Auf diese Weise ist es möglich, die Offset-Kompensation in sehr präziser Weise zu erreichen, wobei die Offset-Kompensation hier geringen Toleranzen unterliegt.

Bei einem bevorzugten Ausführungsbeispiel ist der Delta-Sigma-Modulator ausgelegt, um den zweiten Anschluss der Offset-Kapazität und den zweiten Anschluss der zu messenden Kapazität über einen gemeinsamen Schalter mit dem Ladungs-Summationsknoten zu verbinden. Dies stellt eine besonders effiziente Realisierung dar.

Bei einem weiteren bevorzugten Ausführungsbeispiel ist der Delta-Sigma-Modulator ausgelegt, um an den Ladungs-Summationsknoten zumindest einen Ausschnitt aus einem sinusförmigen Stromverlauf anzulegen. Dies ermöglicht wiederum eine vergleichsweise störungsarme Bereitstellung einer Kompensationsladung.

Ein weiteres Ausführungsbeispiel umfasst ein Sensorsystem mit einer Sensorkapazität, die ausgelegt ist, um einen Kapazitätswert in Abhängigkeit von einer zu messenden Größe um mindestens 20 % zu verändern. Das Sensorsystem umfasst ferner eine oben beschriebene Kapazitätsmessschaltung. Die Kapazitätsmessschaltung ist dabei mit der Sensorkapazität gekoppelt, so dass die Sensorkapazität die zu messende Kapazität bildet. Ein derartiges Sensorsystem bietet die oben bereits erläuterten Vorteile.

Bei einem bevorzugten Ausführungsbeispiel ist die Kapazitätsmessschaltung bei dem genannten Sensorsystem ausgelegt, um unter der Annahme einer bekannten Amplitude des von der Messspannungsquelle gelieferten sinusförmigen Spannungssignals eine Auswertung durchzuführen, um eine Information zu erhalten, die den Kapazitätswert der Sensorkapazität beschreibt. Dementsprechend kann auf den Kapazitätswert der Sensorkapazität zurückgeschlossen werden, und die Information über den Kapazitätswert der Sensorkapazität kann ausgegeben werden oder weiterverarbeitet werden, um beispielsweise eine Information über einen Zustand eines Apparats zu erhalten.

Bei einem bevorzugten Ausführungsbeispiel gemäß der Erfindung bildet die Sensorkapazität eine Eingangskapazität des Delta-Sigma-Modulators.

Ein weiteres Ausführungsbeispiel gemäß der Erfindung schafft ein Verfahren zur Kapazitätsmessung. Dieses Verfahren basiert auf denselben Erkenntnissen wie die oben beschriebene Kapazitätsmessschaltung.

Figurenkurzbeschreibung

Ausführungsbeispiele gemäß der vorliegenden Erfindung werden nachfolgend Bezug nehmend auf die beiliegenden Figuren näher erläutert. Es zeigen:

Fig. 1    ein Blockschaltbild einer Kapazitätsmessschaltung gemäß einem Ausführungsbeispiel der vorliegenden Erfindung;

Fig. 2    ein detailliertes Schaltbild einer Kapazitätsmessschaltung gemäß einem Ausführungsbeispiel der vorliegenden Erfindung;

Fig. 3    ein detailliertes Schaltbild einer Kapazitätsmessschaltung gemäß einem weiteren Ausführungsbeispiel der Erfindung;

Fig. 4a    ein detailliertes Schaltbild einer Kapazitätsmessschaltung gemäß einem weiteren Ausführungsbeispiel der Erfindung;

Fig. 4b    ein detailliertes Schaltbild einer Kapazitätsmessschaltung gemäß einem weiteren Ausführungsbeispiel der Erfindung;

Fig. 4c    ein detailliertes Schaltbild einer Kapazitätsmessschaltung gemäß einem weiteren Ausführungsbeispiel der Erfindung;

Fig. 5    ein Taktschema für einen Sigma-Delta-Modulator mit einer sinusförmigen Anregung;

Fig. 6a    ein Prinzipschaltbild einer Schalter-Kondensator-Technik;

Fig. 6b    ein weiteres Prinzipschaltbild der Schalter-Kondensator-Technik;

Fig. 7    ein Flussdiagramm eines Verfahrens zum Messen einer Kapazität gemäß einem Ausführungsbeispiel der Erfindung;

Fig. 8    eine schematische Darstellung des Prinzips eines Delta-Sigma-Modulators;

Fig. 9    ein detailliertes Schaltbild eines herkömmlichen Sigma-Delta-Modulators zur Messung eines Spannungssignals; und

Fig. 10    ein detailliertes Schaltbild einer herkömmlichen Kapazitätsmessschaltung mittels eines "Standard"-Sigma-Delta-Modulators.

Detaillierte Beschreibung der Ausführungsbeispiele

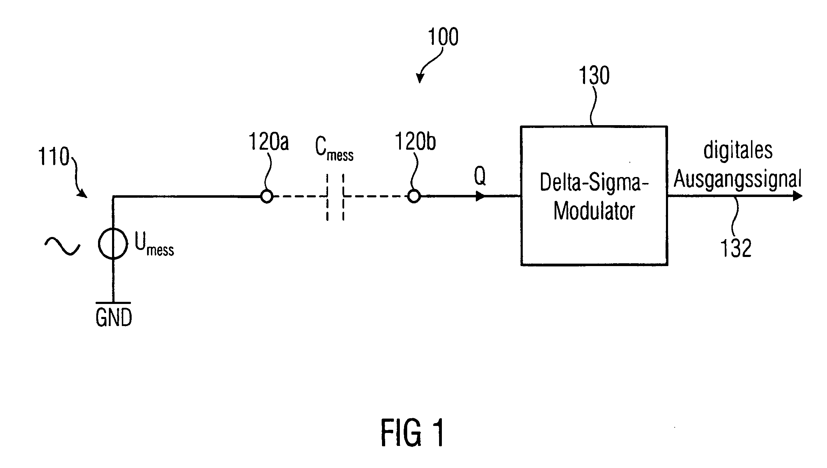

1. Kapazitätsmessschaltung gemäß der Fig. 1

Fig. 1 zeigt ein Blockschaltbild einer Kapazitätsmessschaltung 100 gemäß einem Ausführungsbeispiel der Erfindung. Die Kapazitätsmessschaltung 100 umfasst eine Messspannungsquelle 110, die ausgelegt ist, um einem ersten Anschluss 120a einer zu messenden Kapazität Cmess ein sinusförmiges Spannungssignal zuzuführen, um somit eine zeitliche Änderung einer in der zu messenden Kapazität Cmess gespeicherten Ladung zu bewirken. Die Kapazitätsmessschaltung 100 umfasst ferner einen Delta-Sigma-Modulator 130. Der Delta-Sigma-Modulator 130 ist ausgelegt, um von einem zweiten Anschluss 120b der zu messenden Kapazität Cmess eine Ladung zu erhalten und um ein digitales Ausgangssignal 132 bereitzustellen, das von einer Größe der von der zu messenden Kapazität Cmess erhaltenen Ladung abhängig ist.

Im Hinblick auf die Funktionsweise der *Kapazitätsmessschaltung* 100 ist anzumerken, dass durch das sinusförmige Spannungssignal 110, das an dem ersten Anschluss 120a der zu messenden Kapazität Cmess anliegt, eine zeitliche Veränderung der in der zu messenden Kapazität Cmess gespeicherten Ladung bewirkt wird. So kommt es typischerweise während eines Teils einer Periode des sinusförmigen Spannungssignals (beispielsweise während einer ersten Phase) zu einer Vergrößerung der auf der zu messenden Kapazität Cmess gespeicherten Ladung. Während einer zweiten Phase hingegen, die beispielsweise einen Teil einer Periode des sinusförmigen Spannungssignals ausmacht, kommt es zu einer Verringerung einer auf der zu messenden Kapazität Cmess gespeicherten Ladung (bzw. zu einer Veränderung des Vorzeichens der gespeicherten Ladung). Der Delta-Sigma-Modulator 130 ist dabei ausgelegt, um von dem zweiten Anschluss der zu messenden Kapazität Cmess eine Ladung zu erhalten, die beispielsweise von der zu messenden Kapazität Cmess abfließt, wobei eine zeitliche Veränderung des sinusförmigen Spannungssignals, das an dem ersten Anschluss 120a der zu messenden Kapazität Cmess anliegt, die Ursache für einen Abfluss von Ladung von der Kapazität Cmess bilden kann. Der Delta-Sigma-Modulator 130 ist dabei in der Lage, das digitale Ausgangssignal 132 bereitzustellen, so dass das digitale Ausgangssignal 132 eine Größe der von der zu messenden Kapazität erhaltenen Ladung Q beschreibt. Somit beschreibt das digitale Ausgangssignal 132 gleichzeitig, unter der Annahme, dass ein Spannungsverlauf des sinusförmigen Spannungssignals bekannt ist, die zu messende Kapazität Cmess, da typischerweise die empfangene Ladung Q proportional zu einem Kapazitätswert der zu messenden Kapazität Cmess ist.

Insofern ermöglicht es das digitale Ausgangssignal 132, eine Auswertung durchzuführen, um auf den Kapazitätswert der zu messenden Kapazität Cmess zu schließen, was bei einigen Ausführungsbeispielen auch gemacht wird.

Weitere Details, wie genau die Kapazitätsmessschaltung 100 aufgebaut sein kann, werden im Folgenden beschrieben.

Ergänzend sei im Übrigen darauf hingewiesen, dass hier unter einem sinusförmigen Spannungssignal auch ein näherungsweise sinusförmiges Spannungssignal verstanden wird. Beispielsweise wurde herausgefunden, dass eine Abweichung des von der Messspannungsquelle 100 gelieferten Spannungssignals von einem ideal sinusförmigen Spannungsverlauf von beispielsweise 10 %, bezogen auf eine Amplitude des ideal sinusförmigen Spannungsverlaufs, typischerweise noch zu guten Ergebnissen führt. Insbesondere wird durch die Verwendung eines zumindest näherungsweise sinusförmigen Spannungssignals vermieden, dass ein Spannungsverlauf auf den Elektroden der zu messenden Kapazität bzw. ein Stromverlauf in den Anschlussleitungen, die mit der zu messenden Kapazität Cmess gekoppelt sind, einen starken Oberwellenanteil aufweist.

Insofern ist eine elektromagnetische Verträglichkeit der Kapazitätsmessschaltung 100 typischerweise deutlich besser als die elektromagnetische Verträglichkeit von herkömmlichen Kapazitätsmessschaltungen, die einen Delta-Sigma-Modulator verwenden.

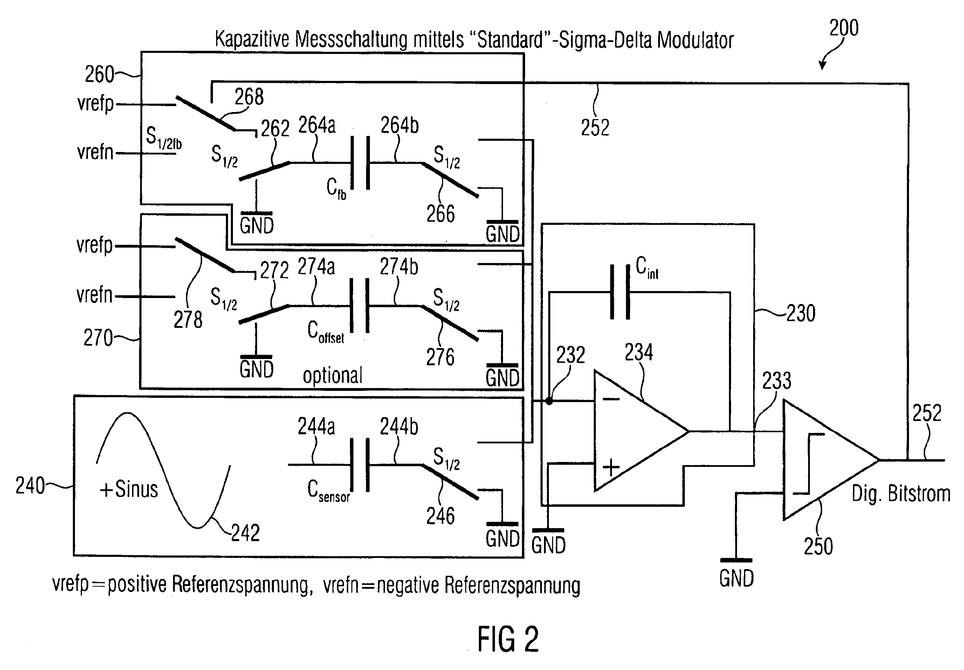

*2. Kapazitätsmessschaltung gemäß Fig. 2*

Im Folgenden wird anhand der Fig. 2 eine Kapazitätsmessschaltung im Detail erläutert. Fig. 2 zeigt ein detailliertes Schaltbild einer derartigen Kapazitätsmessschaltung 200.

Die Kapazitätsmessschaltung 200 umfasst als ein zentrales Element einen Ladungsintegrator 230. Der Ladungsintegrator 230 weist einen eingangsseitigen Ladungs-Summationsknoten 232 und einen Integrationsergebnisausgang 233 auf.

Die Kapazitätsmessschaltung weist ferner eine Messladungs-Bereitstellungsschaltung 240 auf, die ausgelegt ist, um dem Ladungs-Summationsknoten 232 eine (positive oder negative) Ladungsmenge zuzuführen, deren Größe von einem Kapazitätswert der zu messenden Kapazität Csensor abhängig ist.

Die Kapazitätsmessschaltung 200 weist ferner eine Rückkopplungs-Ladungsbereitstellungsschaltung 260 auf, die ausgelegt ist, um dem Ladungs-Summationsknoten 232 eine (positive oder negative) Ladungsmenge in Abhängigkeit von einem Steuersignal 252 zuzuführen. Das Steuersignal 252 entscheidet dabei darüber, ob die Rückkopplungs-Ladungsbereitstellungsschaltung 260 dem Ladungs-Summationsknoten 232 eine erste Ladungsmenge (z. B. eine positive Ladungsmenge) oder eine zweite Ladungsmenge (z. B. eine negative Ladungsmenge) zuführt.

Die Kapazitätsmessschaltung umfasst ferner einen Offset-Ladungsbereitsteller 270, der ausgelegt ist, um dem Ladungs-Summationsknoten 232 während eines Taktzyklus des Delta-Sigma-Modulators eine fest vorgegebene oder wählbare Ladungsmenge zuzuführen. Der Offset-Ladungsbereitsteller 270 ist im Übrigen als optional anzusehen.

Die Kapazitätsmessschaltung umfasst ferner einen Schwellwertentscheider 250. Ein Eingang des Schwellwertentscheiders 250 ist beispielsweise mit dem Integrationsergebnisausgang 233 des Ladungsintegrators 230 gekoppelt. Ein zweiter Eingang (z. B. ein Referenzeingang) des Schwellwertentscheiders 250 ist beispielsweise mit dem Bezugspotential GND gekoppelt. Ein Ausgang des Schwellwertentscheiders 250 liefert einen digitalen Bitstrom 252, beispielsweise eine zeitdiskrete Folge von zwei verschiedenen Werten (z. B. logisch "0" und logisch "1"). Die Werte des digitalen Bitstroms 252 können gleichzeitig das Steuersignal für den Rückkopplungs-Ladungsbereitsteller 260 bilden und somit entscheiden, ob während eines (Takt-) Zyklus des Delta-Sigma-Modulators dem Ladungs-Summationsknoten 232 durch den Rückkopplungs-Ladungsbereitsteller 260 eine erste Ladungsmenge (z. B. eine positive Ladungsmenge) oder eine zweite Ladungsmenge (z. B. eine negative Ladungsmenge) zugeführt wird.

Im Folgenden wird die Struktur der einzelnen Komponenten der Kapazitätsmessschaltung 200 näher beschrieben.

Der Ladungsintegrator 230 umfasst beispielsweise einen Operationsverstärker 234 sowie eine Ladungsintegrationskapazität Cint. Ein nicht-invertierender Eingang (+) des Operationsverstärkers 234 ist beispielsweise mit dem Bezugspotential GND gekoppelt. Ein invertierender Eingang (-) des Operationsverstärkers 234 ist im Übrigen mit dem Ladungs-Summationsknoten 232 gekoppelt. Die Integrationskapazität Cint ist im Übrigen zwischen den Ladungs-Summationsknoten 232 und einen Ausgang des Operationsverstärkers 234 geschaltet. Der Operationsverstärker 234 stellt somit - im Rahmen des Möglichen und im Rahmen von parasitären Störgrößen, wie etwa einer Eingangs-Offsetspannung - sicher, dass das Potential an dem Ladungsintegrationsknoten 232 gleich dem Bezugspotential GND ist. Ferner sind die Eingänge des Operationsverstärkers 234 typischerweise hochohmig (Eingangswiderstand im Megaohm-Bereich), so dass nur ein vernachlässigbar geringer Strom in die Eingänge des Operationsverstärkers hineinfließt bzw. aus diesen herausfließt. Die Integrationskapazität Cint integriert somit die Summe von Ladungen (positiven und negativen Ladungen) auf, die dem Ladungs-Summationsknoten 232 durch den Mess-Ladungsbereitsteller 240, den Rückkopplungs-Ladungsbereitsteller 260 und gegebenenfalls den Offset-Ladungsbereitsteller 270 zugeführt werden. Eine Spannung an dem Integrationsergebnisausgang 233 ist beispielsweise proportional zu einer Größe der auf der Integrationskapazität Cint aufintegrierten Ladung, wobei diese Ladung beispielsweise sowohl positiv als auch negativ sein kann.

Der Schwellwertvergleicher 250 vergleicht beispielsweise den Spannungspegel an dem Integrationsergebnisausgang 233 mit einem vorgegebenen Referenzwert, z. B. mit dem Bezugspotential GND. Der Schwellwertvergleicher 250 stellt an seinem Ausgang somit ein wertdiskretes (z. B. binäres oder dreiwertiges) Signal bereit, das angibt, ob der Spannungspegel an dem Integrationsergebnisausgang 233 größer oder kleiner als eine Referenzspannung (die beispielsweise gleich 0, bezogen auf das Bezugspotential, sein kann) ist. Somit liefert der Schwellwertvergleicher 250 beispielsweise ein wertdiskretes (z. B. binäres) Signal, das eine Größe der auf der Integrationskapazität Cint gespeicherten Ladung bzw. ein Vorzeichen der auf der Integrationskapazität Cint gespeicherten Ladung beschreibt. Das Ausgangssignal des Schwellwertvergleichers 250 kann im Übrigen in getakteter Weise aktualisiert werden, um so einen zeitdiskreten und wertdiskreten digitalen Bitstrom 252 zu erhalten.

Der Mess-Ladungsbereitsteller 240 umfasst beispielsweise eine Mess-Spannungsquelle, die ein zumindest näherungsweise sinusförmiges Spannungssignal 242 bereitstellt. Das Mess-Spannungssignal 242 wird beispielsweise einer zu messenden Kapazität bzw. Sensorkapazität Csensor zugeführt und zwar an einem ersten Anschluss 244a. Ein zweiter Anschluss 244b der zu messenden Kapazität ist über einen Umschalter 246 alternativ mit einer Bezugspotentialzuführung für das Bezugspotential GND oder dem Ladungs-Summationsknoten 232 koppelbar. Typischerweise ist der Mess-Ladungsbereitsteller 240 so ausgelegt, dass der zweite Anschluss 244b der zu messenden Kapazität während einer ersten Phase mit der Bezugspotentialzuführung für das Bezugspotential GND gekoppelt ist, und dass der zweite Anschluss 244b der zu messenden Kapazität Csensor während einer zweiten Phase, die zeitlich nicht-überlappend zu der ersten Phase ist, stattdessen mit dem Ladungs-Summationsknoten 232 gekoppelt ist. Somit wird auf die zu messende Kapazität Csensor in der ersten Phase, in der der zweite Anschluss 244b der zu messenden Kapazität Csensor mit der Bezugspotentialzuführung gekoppelt ist, eine erste Ladungsmenge aufgebracht, deren Endwert im Wesentlichen durch ein Produkt aus der Größe der Sensorkapazität Csensor und einem Spannungswert der sinusförmigen Spannung an dem ersten Anschluss 244a der zu messenden Kapazität Csensor am Ende der ersten Phase bestimmt wird.

Durch die Verbindung des zweiten Anschlusses 244b mit der Bezugspotentialzuführung wird im Übrigen sichergestellt, dass an dem zweiten Anschluss 244b während der ersten Phase im Wesentlichen das Bezugspotential GND anliegt.

Während der zweiten Phase wird im Übrigen durch den Operationsverstärker 234 sichergestellt, dass an dem zweiten Anschluss 244b ebenso das Bezugspotential GND anliegt, da der Ladungs-Summationsknoten 232 als Virtuelle-Masse-Knoten wirkt.

Somit verändert sich eine auf der zu messenden Kapazität gespeicherte Ladungsmenge während der zweiten Phase, wobei die an dem Ende der zweiten Phase auf der zu messenden Kapazität vorliegende Ladungsmenge im Wesentlichen durch ein Produkt aus dem Kapazitätswert der zu messenden Kapazität Csensor und einen zum Ende der zweiten Phase an dem ersten Anschluss 244a anliegenden Spannungswert (bezogen auf das Bezugspotential GND) bestimmt wird. Im Übrigen kann typischerweise davon ausgegangen werden, dass zu Beginn der zweiten Phase die gleiche Ladungsmenge auf der zu messenden Kapazität Csensor gespeichert ist wie zum Ende der ersten Phase.

Somit ergibt sich, dass sich während der zweiten Phase die auf der Kapazität Csensor gespeicherte Ladungsmenge von der zum Ende der ersten Phase gespeicherten Ladungsmenge auf die zum Ende der zweiten Phase gespeicherte Ladungsmenge verändert. Die Veränderung der Ladungsmenge entspricht damit im Wesentlichen einem Produkt aus dem Kapazitätswert der zu messenden Kapazität Csensor und der Differenz zwischen zwei Spannungswerten U1, U2, die zum Ende der ersten Phase bzw. zum Ende der zweiten Phase an dem ersten Anschluss 244a der zu messenden Kapazität Csensor vorliegen. Eine Ladungsmenge, die gleich dem Unterschied zwischen der zum Ende der ersten Phase auf der Kapazität Csensor gespeicherten Ladungsmenge und der zum Ende der zweiten Phase auf der Kapazität Csensor gespeicherten Ladungsmenge ist, wird im Übrigen dem Ladungs-Summationsknoten 232 während der zweiten Phase von der Messladungs-Bereitstellungsschaltung 240 zugeführt. Die entsprechende Ladungsmenge kann positiv oder negativ sein, je nachdem, ob die Spannung an dem ersten Anschluss 244a zum Ende der ersten Phase größer oder kleiner als die Spannung an dem ersten Anschluss 244a zum Ende der zweiten Phase ist.

Im Übrigen sei noch darauf hingewiesen, dass die zu messende Kapazität Csensor bei einigen Ausführungsbeispielen Teil des Delta-Sigma-Modulators sein kann. Beispielsweise kann die zu messende Kapazität Csensor eine Eingangskapazität des Delta-Sigma-Modulators darstellen. Allerdings kann die zu messende Kapazität Csensor bei anderen Ausführungsbeispielen auch extern zu dem Delta-Sigma-Modulator sein und beispielsweise entfernt von der eigentlichen Delta-Sigma-Modulatorschaltung angeordnet sein.

Die Rückkopplungs-Ladungsbereitstellungsschaltung 260 umfasst im Übrigen eine Rückkopplungskapazität Cfb. Ein erster Anschluss 264a der Rückkopplungskapazität Cfb ist über einen Schalter 262 (erster Schalter der Rückkopplungs-Ladungsbereitstellungsschaltung 260) alternativ mit einer Bezugspotentialzuführung für ein Bezugspotential GND und einem Mittelanschluss eines Schalters 268 (dritter Schalter der Rückkopplungs-Ladungsbereitstellungsschaltüng 260) koppelbar.

Ein zweiter Anschluss 264b der Rückkopplungskapazität Cfb ist über einen Schalter 266 (zweiter Schalter der Rückkopplungs-Ladungsbereitstellungsschaltung 260 ) alternativ mit einer Bezugspotentialzuführung für das Bezugspotential GND und dem Ladungs-Summationsknoten 232 koppelbar. Die Schalter 262, 266 werden typischerweise so angesteuert, dass in der ersten Phase des Sigma-Delta-Modulators die beiden Anschlüsse 264a, 264b der Rückkopplungskapazität mit einer Bezugspotentialzuführung für das Bezugspotential GND gekoppelt sind, so dass die Rückkopplungskapazität Cfb während der ersten Phase entladen wird. Während der zweiten Phase hingegen wird der erste Anschluss 264a der Rückkopplungskapazität Cfb beispielsweise mit dem Mittelanschluss des Schalters 268 gekoppelt und der zweite Anschluss 264b wird mit dem Ladungs-Summationsknoten 232 gekoppelt. In der zweiten Phase wird im Ergebnis der erste Anschluss 264a der Rückkopplungskapazität Cfb über den Schalter 262 und den Schalter 268 in Abhängigkeit von einem aktuellen (oder vorherigen) Wert des digitalen Bitstroms 252 mit einem positiven Referenzpotential vrefp oder. einem negativen Referenzpotential vrefn gekoppelt.

Somit wird insgesamt dem Ladungs-Summationsknoten 232 in der zweiten Phase eine positive Ladung der Größe Qfb+ = Cfb * vrefp durch den Rückkopplungs-Ladungsbereitsteller 260 zugeführt, wenn der aktuelle Wert des digitalen Bitstroms 252 einen ersten Wert annimmt. Alternativ dazu wird dem Ladungs-Summationsknoten 232 durch den Rückkopplungs-Ladungsbereitsteller 260 eine negative Ladung Qfb - = Cfb * vrefn zugeführt, wenn der aktuelle Wert des digitalen Bitstroms 252 einen zweiten Wert annimmt. Insgesamt dient der Rückkopplungs-Ladungsbereitsteller 260 somit dazu, dem Ladungs-Summationsknoten 232 in der zweiten Phase des Delta-Sigma-Modulators alternativ und abhängig von dem aktuellen Wert des digitalen Bitstroms 252 eine vorgegebene positive Ladungsmenge oder eine vorgegebene negative Ladungsmenge zuzuführen.

Die Offset-Ladungsbereitstellungsschaltung 270 umfasst beispielsweise eine Offset-Kapazität Coffset. Ein erster Anschluss 274a der Offset-Kapazität ist über einen Schalter 272 (erster Schalter der Offset-Ladungsbereitstellungsschaltung 270) mit einer Bezugspotentialzuführung für das Bezugspotential GND koppelbar und ferner über den Schalter 272 mit einem Mittelabgriff eines Schalters 278 (dritter Schalter der Offset-Ladungsbereitstellungsschaltung 270 ) koppelbar. Ein zweiter Anschluss 274b der Offset-Kapazität Coffset ist über einen Schalter 276 (zweiter Schalter der Offset-Ladungsbereitstellungsschaltung 270) alternativ mit einer Bezugspotentialzuführung für das Bezugspotential GND und dem Ladungs-Summationsknoten 232 koppelbar. In der ersten Phase des Sigma-Delta-Modulators sind typischerweise sowohl der erste Anschluss 274a der Offset-Kapazität Coffset als auch der zweite Anschluss 274b der Offset-Kapazität Coffset über die Schalter 272, 276 mit der Bezugspotentialzuführung für das Bezugspotential GND gekoppelt, so dass die Offset-Kapazität Coffset während der ersten Phase entladen wird. In der zweiten Phase hingegen ist der erste Anschluss 274a der Offset-Kapazität Coffset über die Schalter 272, 278 mit einem vorbestimmten Referenzpotential gekoppelt, beispielsweise mit dem positiven Referenzpotential vrefp oder dem negativen Referenzpotential vrefn. Gleichzeitig ist in der zweiten Phase der zweite Anschluss 274b der Offset-Kapazität Coffset über den Schalter 276 mit dem Ladungs-Summationsknoten 232 gekoppelt.

Somit wird effektiv dem Ladungs-Summationsknoten 232 während der zweiten Phase eine Ladung durch die Offset-Ladungsbereitstellungsschaltung zugeführt, wobei die durch die Offset-Ladungsbereitstellungsschaltung zugeführte Ladung Qoffset durch das Produkt eines Kapazitätswerts der Offset-Kapazität Coffset und eine entsprechende Spannung (beispielsweise vrefp, vrefn), die in der zweiten Phase an den ersten Anschluss 274a der Offset-Kapazität Coffset angelegt wird, bestimmt ist. Insofern ist die optionale Offset-Ladungsbereitstellungsschaltung 270 ausgelegt, um dem Ladungs-Summationsknoten 232 in der zweiten Phase eine vorgegebene Ladungsmenge zuzuführen, die die dem Ladungs-Summationsknoten durch die Messladungs-Bereitstellungsschaltung 240 zugeführte Ladung zumindest teilweise kompensiert, in manchen Fällen sogar überkompensiert.

Im Hinblick auf die Funktionsweise der Gesamtschaltung 200 ist nunmehr zu sagen, dass während eines Zyklus, der beispielsweise die erste Phase und die zweite Phase als nichtüberlappende Phasen umfasst, dem Ladungs-Summationsknoten 232 durch die MessLadungs-Bereitstellungsschaltung 240 eine Ladungsmenge Qsensor zugeführt wird, durch die Offset-Ladungsbereitstellungsschaltung 270 eine Ladungsmenge Qoffset zugeführt wird und durch die Rückkopplungs-Ladungsbereitstellungsschaltung 260 eine Ladungsmenge Qfb zugeführt wird.

Die durch die Messladungs-Bereitstellungsschaltung 240 dem Ladungs-Summationsknoten 232 zugeführte Ladung ist beispielsweise bei vorgegebener und bekannter Amplitude der an dem ersten Anschluss 244a der zu messenden Kapazität Csensor anliegenden sinusförmigen Wechselspannung, und bei einer konstanten zeitlichen Synchronisation zwischen der sinusförmigen Wechselspannung und den Phasen des Sigma-Delta-Modulators im Wesentlichen proportional zu dem Kapazitätswert der zu messenden Kapazität. Die von der Offset-Ladungsbereitstellungsschaltung 270 an den Ladungs-Summationsknoten 232 gelieferte Ladungsmenge ist im Wesentlichen konstant, da davon ausgegangen wird, dass die dem ersten Anschluss 274a der Offset-Kapazität Coffset in der zweiten Phase zugeführte Spannung im Wesentlichen konstant ist, und dass ein Kapazitätswert der Offset-Kapazität auch im Wesentlichen konstant oder zumindest fest vorgegeben (und bekannt) ist.

Die dem Ladungs-Summationsknoten 232 durch die Rückkopplungs-Ladungsbereitstellungsschaltung 260 zugeführte Ladung nimmt im Übrigen einen von zwei bekannten Werten an, und zwar abhängig von dem aktuellen Wert des digitalen Bitstroms 252. Ob dem Ladungs-Summationsknoten 232 in einem gegebenen Zyklus während der zweiten Phase durch die Rückkopplungs-Ladungsbereitstellungsschaltung 260 eine positive Ladung oder eine negative Ladung zugeführt wird, hängt im Wesentlichen davon ab, ob die Ladung auf der Integrationskapazität Cint am Ende des vorhergehenden Zyklus positiv oder negativ war. Somit wird bei Vorliegen einer positiven Ladung auf der Integrationskapazität Cint in dem vorherigen Zyklus darauf hingewirkt, dass die Ladung auf der Integrationskapazität Cint verkleinert wird (weniger positiv wird bzw. negativ wird). Im Gegensatz dazu wird bei Vorliegen einer negativen Ladung auf der Integrationskapazität Cint in dem vorherigen Zyklus darauf hingewirkt, dass die Ladung auf der Integrationskapazität Cint positiver wird. Wie oft dabei (in einer Folge von Zyklen des Delta-Sigma-Modulators) dem Ladungs-Summationsknoten 232 durch die Rückkopplungs-Ladungsbereitstellungsschaltung 260 eine positive Ladung und eine negative Ladung bereitgestellt wird, hängt davon ab, wie groß die Summe aus der Ladung Qsensor und aus der Ladung Qoffset ist, und ob die Summe der Ladungen Qsensor und Qoffset positiv oder negativ ist. Je nachdem, welchen Wert die Summe Qsensor + Qoffset annimmt, umfasst der digitale Bitstrom 252 beispielsweise mehr oder weniger Nullen bzw. Einsen. Ist beispielsweise Qsensor + Qoffset gleich 0, so ist zumindest näherungsweise zu erwarten, dass der digitale Bitstrom 252 genauso viele Nullen und Einsen umfasst. Ist hingegen Qoffset + Qsensor größer als 0 bzw. kleiner als 0, so verschiebt sich das Gleichgewicht an Nullen und Einsen und es überwiegen entweder Nullen oder Einsen in dem digitalen Bitstrom 252.

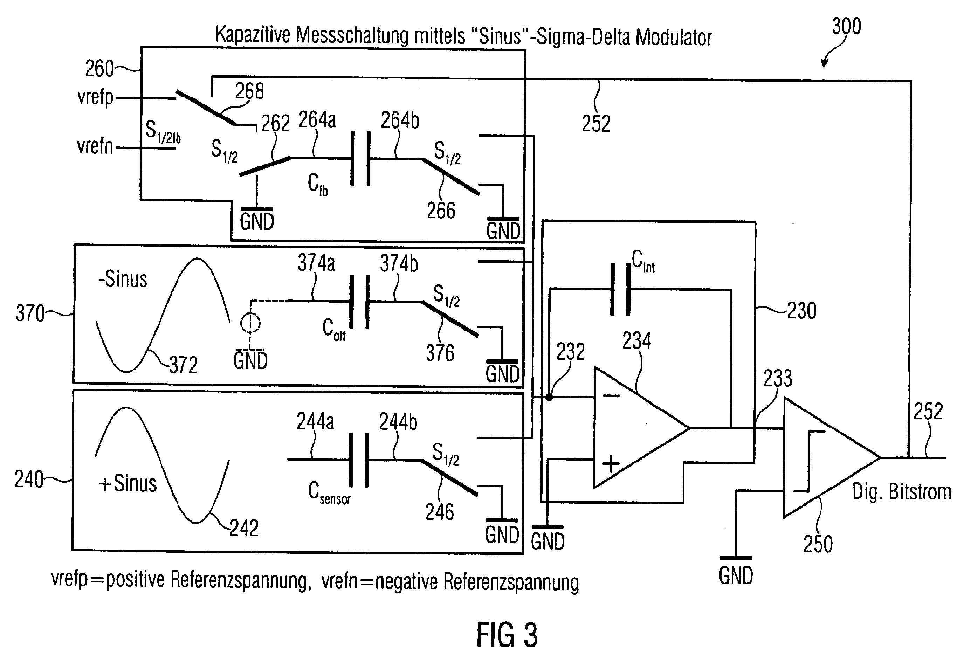

### 3. Kapazitätsmessschaltung gemäß Fig. 3

Im Folgenden wird kurz ein weiteres Ausführungsbeispiel einer erfindungsgemäßen Kapazitätsmessschaltung Bezug nehmend auf die Fig. 3 beschrieben. Fig. 3 zeigt ein detailliertes Schaltbild einer solchen Kapazitätsmessschaltung 300. Die Kapazitätsmessschaltung 300 ähnelt von ihrem Aufbau und ihrer Funktionsweise her sehr stark der Kapazitätsmessschaltung 200 gemäß Fig. 2. Gleiche bzw. gleich wirkende Schaltungselemente und Signale sind daher mit den gleichen Bezugszeichen bezeichnet und werden hier nicht noch einmal erläutert.

Die Kapazitätsmessschaltung 300 gemäß der Fig. 3 unterscheidet sich von der Kapazitätsmessschaltung 200 gemäß Fig. 2 im Wesentlichen dadurch, dass die Offset-Ladungsbereitstellungsschaltung 270 durch eine modifizierte Offset-Ladungsbereitstellungsschaltung 370 ersetzt ist.

Die modifizierte Offset-Ladungsbereitstellungsschaltung 370 umfasst eine Offset-Kapazität Coff. Die modifizierte Offset-Ladungsbereitstellungsschaltung 370 umfasst ferner eine Spannungsquelle, die ausgelegt ist, um ein zumindest näherungsweise sinusförmiges Spannungssignal 372 an einen ersten Anschluss 374a der Offset-Kapazität Coff anzulegen. Die modifizierte Offset-Ladungsbereitstellungsschaltung 370 umfasst ferner einen Schalter 376, der ausgelegt ist, um einen zweiten Anschluss 374b der Offset-Kapazität Coff in der ersten Phase mit einer Bezugspotentialzuführung für das Bezugspotential GND zu verbinden, und um den zweiten Anschluss 374b der Offset-Kapazität Coff in der zweiten Phase mit dem Ladungs-Summationsknoten 232 zu verbinden. Das von der Spannungsquelle an den ersten Anschluss 374a der Offset-Kapazität Coff angelegte zumindest näherungsweise sinusförmige Spannungssignal ist bevorzugt gegenphasig zu (d. h. um 180 Grad phasenverschoben zu) dem zumindest näherungsweise sinusförmigen Spannungssignal, das an dem ersten Anschluss 244a der zu messenden Kapazität Csensor anliegt.

Eine Amplitude des an dem ersten Anschluss 374a der Offset-Kapazität anliegenden sinusförmigen Spannungssignals kann gleich einer Amplitude des an dem ersten Anschluss 244a der zu messenden Kapazität Csensor anliegenden sinusförmigen Spannungssignals sein oder sich von dieser Amplitude unterscheiden. Bevorzugt ist ein Produkt aus einer Amplitude des an dem ersten Anschluss 244a der zu messenden Kapazität anliegenden sinusförmigen Signals und einem mittleren Kapazitätswert der zu messenden Kapazität Csensor in etwa (beispielsweise mit einer Toleranz von +/- 10 % oder +/- 20 %) gleich einem Produkt aus einer Amplitude des an dem ersten Anschluss 374a der Offset-Kapazität Coff anliegenden Spannungssignals und dem Kapazitätswert der Offset-Kapazität Coff. Somit ist sichergestellt, dass die von der Offset-Ladungsbereitstellungsschaltung 370 bereitgestellte Ladung zumindest näherungsweise die von der Mess-Ladungs-Bereitstellungsschaltung 240 bereitgestellte Ladung kompensiert. Dadurch kann beispielsweise die Empfindlichkeit der Kapazitätsmessschaltung verbessert werden.

Wesentlich ist hier, dass nunmehr an dem ersten Anschluss 374a bzw. an der ersten Elektrode der Offset-Kapazität Coff ein im Wesentlichen kontinuierliches sinusförmiges Spannungssignal anliegt, was zu einem günstigen Störungsverhalten führt. An dem zweiten Anschluss 374b der Offset-Kapazität Coff liegt hingegen nahezu durchgehend (mit Ausnahme von kurzen Phasen, in denen der Schalter 376 sich in einem vorübergehenden Zwischenzustand befindet) auf dem Bezugspotential GND. Insofern liegen an der Offset-Kapazität Coff keine pulsartigen Signale an, was zu einem günstigen Störungsverhalten führt. Dasselbe gilt auch für die zu messende Kapazität Csensor.

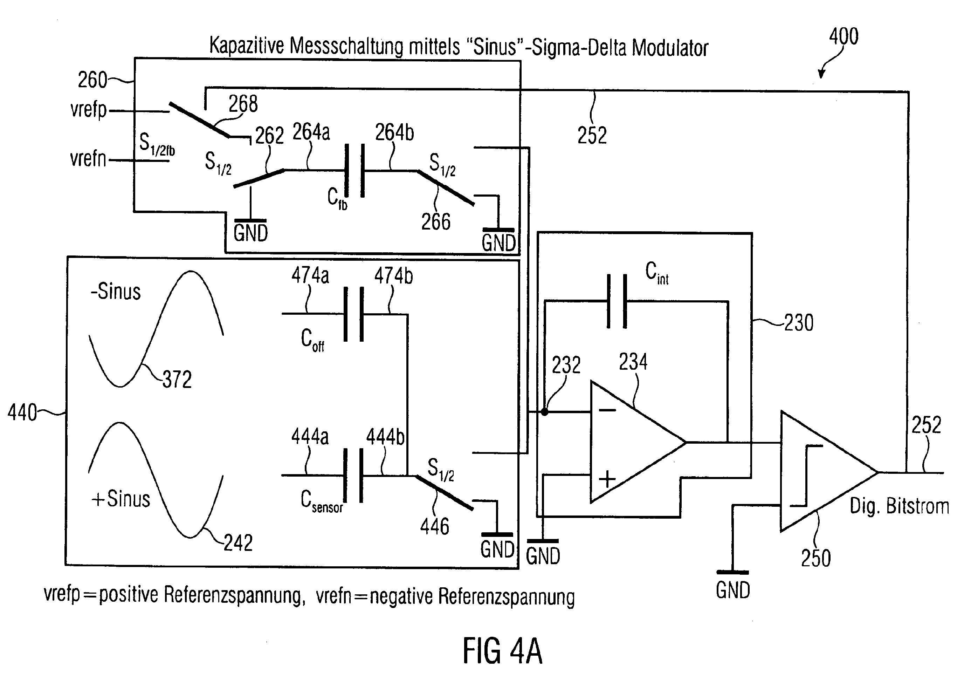

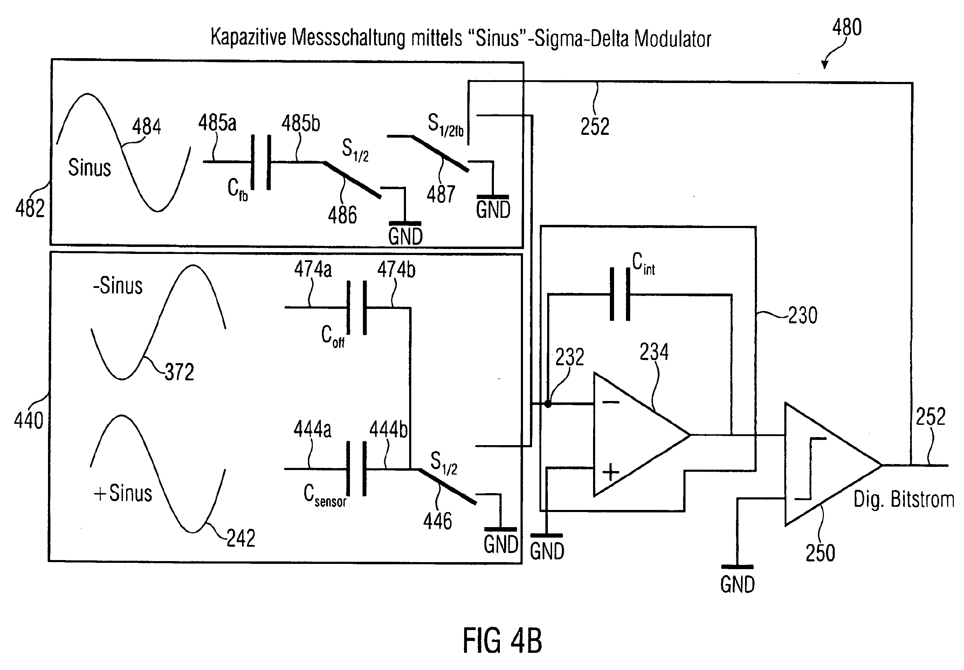

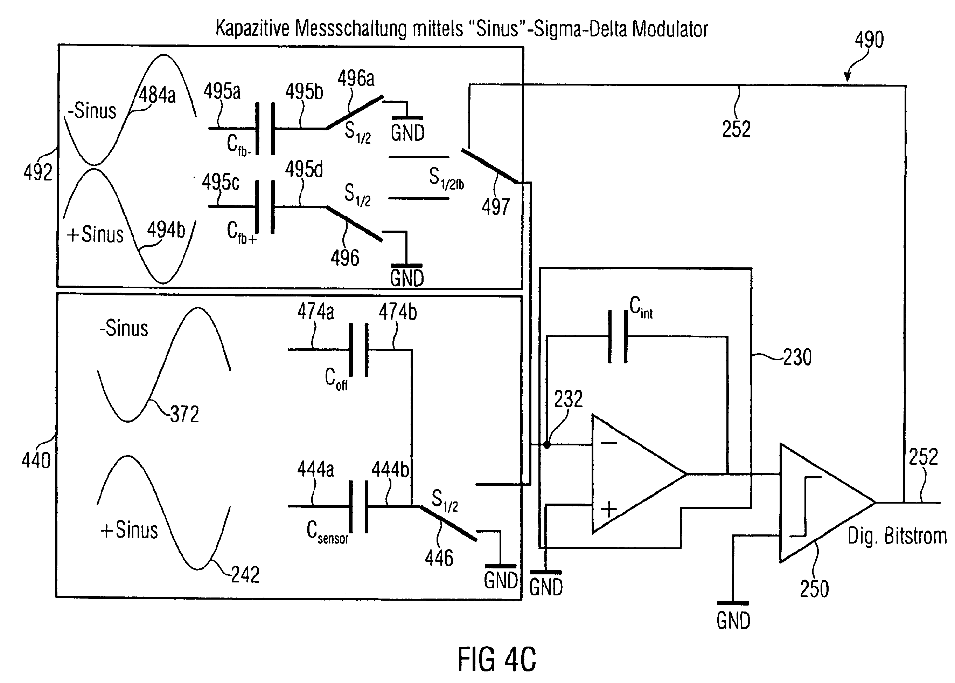

## 4. Kapazitätsmessschaltungen gemäß den Fig. 4a, 4b und 4c

### 4.1. Kapazitätsmessschaltung gemäß Fig. 4a

Fig. 4a zeigt ein detailliertes Schaltbild einer Kapazitätsmessschaltung gemäß einem weiteren Ausführungsbeispiel der Erfindung. Die Kapazitätsmessschaltung ist von ihrer Struktur und Wirkungsweise sehr ähnlich zu der Kapazitätsmessschaltung 200 gemäß Fig. 2 und zu der Kapazitätsmessschaltung 300 gemäß Fig. 3. Aus diesem Grund werden gleiche oder funktional äquivalente Merkmale hier mit gleichen Bezugszeichen bezeichnet und nicht noch einmal erläutert. Vielmehr wird auf die obigen Ausführungen verwiesen.

Die Kapazitätsmessschaltung 400 gemäß Fig. 4a unterscheidet sich von den Kapazitätsmessschaltungen 200 gemäß Fig. 2 und 300 gemäß Fig. 3 im Wesentlichen durch eine andere und schaltungstechnisch besonders einfache Realisierung des Mess-Ladungsbereitstellers 240 sowie des Offset-Ladungsbereitstellers 270 bzw. 370. Die Kapazitätsmessschaltung 400 umfasst eine kombinierte Messladungs-Offsetladungs-Bereitstellungsschaltung 440, die ausgelegt ist, um dem Ladungs-Summationsknoten 232 in der zweiten Phase des Sigma-Delta-Modulators eine Ladung zuzuführen, deren Größe durch eine Differenz zwischen einer Größe der Messladung und einer Größe der Offset-Ladung bestimmt wird.

Die kombinierte Messladungs-Offsetladungs-Bereitstellungsschaltung 440 umfasst eine zu messende Kapazität Csensor und eine Offset-Kapazität Coff. Die kombinierte Messladungs-Offsetladungs-Bereitstellungsschaltung 440 umfasst eine Messspannungsquelle, die ausgelegt ist, um an einem ersten Anschluss 444a der zu messenden Kapazität Csensor ein (zumindest näherungsweise) sinusförmiges erstes Spannungssignal anzulegen. Die kombinierte Messladungs-Offsetladungs-Bereitstellungsschaltung 440 umfasst ferner eine weitere Spannungsquelle, die ausgelegt ist, um an einem ersten Anschluss 474a der Offset-Kapazität ein (zumindest näherungsweise) sinusförmiges zweites Spannungssignal anzulegen. Das von der weiteren Spannungsquelle gelieferte zweite Spannungssignal ist beispielsweise gegenphasig zu dem von der Messspannungsquelle gelieferten ersten Spannungssignal. Amplituden des ersten Spannungssignals und des zweiten Spannungssignals können beispielsweise gleich sein oder aber verschieden sein.

Ein zweiter Anschluss 444b der zu messenden Kapazität Csensor und ein zweiter Anschluss 474b der Offset-Kapazität Coff sind unmittelbar bzw. permanent miteinander gekoppelt (ohne einen dazwischenliegenden Schalter). Der zweite Anschluss 444b der zu messenden Kapazität Csensor und der zweite Anschluss 474b der Offset-Kapazität Coff sind beispielsweise gemeinsam über einen Schalter 446 alternativ mit einer Bezugspotentialzuführung für das Bezugspotential GND und dem Ladungs-Summationsknoten 232 koppelbar.

Somit wird die zu messende Kapazität Csensor während der ersten Phase auf eine Ladung aufgeladen, deren Größe durch die Spannung an dem ersten Anschluss 444a der zu messenden Kapazität Csensor zu dem Ende der ersten Phase und durch den Kapazitätswert der zu messenden Kapazität Csensor bestimmt wird. In ähnlicher Weise wird die Offset-Kapazität Coff während der ersten Phase auf eine Ladung aufgeladen, deren Größe durch die Spannung an dem ersten Anschluss 474a der Offset-Kapazität Coffset zum Ende der ersten Phase und durch den Kapazitätswert der Offset-Kapazität Coffset bestimmt wird. Bevorzugt ist die auf die zu messende Kapazität Csensor in der ersten Phase aufgebrachte Ladung betragsmäßig näherungsweise (z. B. innerhalb eines Toleranzbereichs von 20 %) gleich groß zu der in der ersten Phase auf die Offset-Kapazität Coff aufgebrachten Ladung, was durch eine geeignete Wahl der Kapazitätswerte der zu messenden Kapazität Csensor und der Offset-Kapazität Coff und auch durch eine geeignete Wahl der Amplitude der an den Anschlüssen 444a, 474a anliegenden sinusförmigen Spannungen erreicht werden kann.

In der zweiten Phase verändern sich sowohl die auf der zu messenden Kapazität Csensor gespeicherte Ladung als auch die auf der Offset-Kapazität Coff gespeicherte Ladung, und zwar typischerweise gegenphasig.

Somit fließt über den Schalter 446 in der zweiten Phase nur eine vergleichsweise geringe Ladung zu dem Ladungs-Summationsknoten 232, wobei sich die über den Schalter 446 fließende Ladungsmenge aus der Differenz zwischen einer Veränderung der auf der zu messenden Kapazität Csensor gespeicherten Ladungsmenge und einer Veränderung der auf der Offset-Kapazität gespeicherten Ladungsmenge ergibt. Somit werden Verluste in dem Schalter 446 sehr gering gehalten. Im Übrigen ist die Struktur der Schaltung 400 besonders einfach und die Schaltung 400 kommt mit besonders wenigen Bauteilen aus.

*4.2. Kapazitätsmessschaltung gemäß Fig. 4b*

Fig. 4b zeigt ein detailliertes Schaltbild einer Kapazitätsmessschaltung 480 gemäß einem weiteren Ausführungsbeispiel der Erfindung. Die Kapazitätsmessschaltung ist von ihrer Struktur und Wirkungsweise sehr ähnlich zu der Kapazitätsmessschaltung 200 gemäß Fig. 2, zu der Kapazitätsmessschaltung 300 gemäß Fig. 3 und zu der Kapazitätsmessschaltung 400 gemäß Fig. 4a. Aus diesem Grund werden gleiche oder funktional äquivalente Merkmale hier mit gleichen Bezugszeichen bezeichnet und nicht noch einmal erläutert. Vielmehr wird auf die obigen Ausführungen verwiesen.

Die Kapazitätsmessschaltung 480 gemäß der Fig. 4b unterscheidet sich von der Kapazitätsmessschaltung 400 gemäß der Fig. 4a dadurch, dass an die Stelle des Rückkopplungs-Ladungsbereitstellers 260 der Rückkopplungs-Ladungsbereitsteller 482 tritt.

Der Rückkopplungs-Ladungsbereitsteller 482 umfasst eine Spannungsquelle, die ein zumindest näherungsweise sinusförmiges Spannungssignal 484 liefert. Das zumindest näherungsweise sinusförmige Spannungssignal 484 liegt beispielsweise kontinuierlich bzw. dauerhaft an einem ersten Anschluss 485a der Rückkopplungskapazität Cfb an. Der Rückkopplungs-Ladungsbereitsteller 482 umfasst ferner einen ersten Schalter 486, der ausgelegt ist, um einen zweiten Anschluss 485b der Rückkopplungskapazität Cfb alternativ mit einer Bezugspotentialzuführung für das Bezugspotential GND und einem Mittelanschluss eines zweiten Schalters 487 zu koppeln. Der zweite Schalter 487 ist ausgelegt, um seinen Mittelanschluss abhängig von dem digitalen Bitstrom 252 alternativ mit der Bezugspotentialzuführung für das Bezugspotential GND und dem Ladungs-Summationsknoten 232 zu koppeln.

Im Hinblick auf die Funktionalität des Rückkopplungs-Ladungsbereitstellers 482 ist somit zu sagen, dass die Rückkopplungskapazität Cfb in der ersten Phase, also wenn der erste Schalter 486 den zweiten Anschluss 485b der Rückkopplungskapazität Cfb mit der Bezugspotentialzuführung für das Bezugspotential GND verbindet, auf eine Spannung aufgeladen wird, die durch den Wert des sinusförmigen Spannungssignals 484, das an dem ersten Anschluss 485a der Rückkopplungskapazität Cfb anliegt, zum Ende der ersten Phase bestimmt wird. In der zweiten Phase wird die auf der Rückkopplungskapazität Cfb gespeicherte Ladung verändert, wobei die Veränderung der auf der Rückkopplungskapazität Cfb gespeicherten Ladungsmenge, die sich zwischen dem Ende der ersten Phase und dem Ende der zweiten Phase ergibt, in einer Zuführung bzw. Abführung von Ladung zu bzw. von dem Ladungs-Summationsknoten 232 führt, sofern der zweite Anschluss 485b der Rückkopplungskapazität Cfb mit dem Ladungs-Summationsknoten 232 gekoppelt ist. Indem also der zweite Anschluss 485b der Rückkopplungskapazität Cfb selektiv, in Abhängigkeit von einem aktuellen Wert des digitalen Bitstroms 252, mit dem Ladungs-Summationsknoten gekoppelt wird bzw. von dem Ladungs-Summationsknoten getrennt wird, wird erreicht, dass dem Ladungs-Summationsknoten 232 während der zweiten Phase selektiv eine bestimmte Ladungsmenge von der Rückkopplungskapazität Cfb zugeführt wird. Die Größe. dieser Ladungsmenge wird durch einen Unterschied zwischen der an dem ersten Anschluss 485a der Rückkopplungskapazität Cfb zu dem Ende der ersten Phase anliegenden Spannung und der an dem ersten Anschluss 485a der Rückkopplungskapazität Cfb zu dem Ende der zweiten Phase anliegenden Spannung bestimmt. Die Tatsache, ob dem Ladungs-Summationsknoten 232 Ladung zugeführt wird oder nicht, hängt davon ab, ob der zweite Anschluss 485b der Rückkopplungskapazität Cfb mit dem Ladungs-Summationsknoten 232 gekoppelt ist oder nicht.

Es sei hier darauf hingewiesen, dass es bei dem vorliegenden Ausführungsbeispiel nicht möglich ist, dem Ladungs-Summationsknoten durch die Rückkopplungs-Ladungsbereitstellungsschaltung 482 in Abhängigkeit von dem Wert des digitalen Bitstroms 252 eine positive und eine negative Ladungsmenge bereitzustellen. Vielmehr ist es in dem Ausführungsbeispiel gemäß der Fig. 4b lediglich möglich, dem Ladungs-Summationsknoten 232 durch die Rückkopplungs-Ladungsbereitstellungsschaltung 482 alternativ entweder eine vorbestimmte Ladungsmenge oder keine Ladung zuzuführen. Aus diesem Grund empfiehlt es sich, die kombinierte Messladungs-Offsetladungs-Bereitstellungsschaltung 440 so auszulegen, dass diese dem Ladungs-Summationsknoten unabhängig von der Größe der zu messenden Kapazität Csensor entweder stets eine positive Ladungsmenge oder stets eine negative Ladungsmenge zuführt. Dies kann durch eine geeignete Wahl der Amplituden der sinusförmigen Spannungen bzw. der Kapazitätswerte erreicht werden.

Die Kapazitätsmessschaltung 480 gemäß der Fig. 4b erreicht somit den Vorteil, dass auch die Rückkopplungs-Ladungsbereitstellungsschaltung unter Verwendung eines sinusförmigen Spannungssignals betrieben werden kann. Dies führt in vielen Fällen zu einer deutlichen Reduktion der Störabstrahlung und somit zu einer Verbesserung der elektromagnetischen Verträglichkeit. Außerdem ist es in vielen Fällen vorteilhaft im Hinblick auf die Präzision der Kapazitätsmessung, wenn die Rückkopplungsladung basierend auf einem Spannungssignal erzeugt wird, das den zur Bereitstellung der Messladung bzw. der Offsetladung verwendeten Spannungssignalen weitgehend ähnelt. Fehler, die sich beispielsweise aufgrund von zeitlichen Toleranzen der verschiedenen Phasen ergeben, können somit gering gehalten werden oder sogar ganz eliminiert werden.

Im Übrigen sei darauf hingewiesen, dass die Rückkopplungs-Ladungsbereitstellungsschaltung 482 auch bei den übrigen Kapazitätsmessschaltungen, die hierin beschrieben sind, eingesetzt werden kann.

### 4.3. Kapazitätsmessschaltung gemäß Fig. 4c

Fig. 4c zeigt ein detailliertes Schaltbild einer Kapazitätsmessschaltung 490 gemäß einem weiteren Ausführungsbeispiel der Erfindung. Die Kapazitätsmessschaltung ist von ihrer Struktur und Wirkungsweise sehr ähnlich zu der Kapazitätsmessschaltung 200 gemäß Fig. 2, zu der Kapazitätsmessschaltung 300 gemäß Fig. 3, zu der Kapazitätsmessschaltung 400 gemäß Fig. 4a und zu der Kapazitätsmessschaltung 480 gemäß Fig. 4b. Aus diesem Grund werden gleiche oder funktional äquivalente Merkmale hier mit gleichen Bezugszeichen bezeichnet und nicht noch einmal erläutert. Vielmehr wird auf die obigen Ausführungen verwiesen.

Die Kapazitätsmessschaltung 490 gemäß der Fig. 4c unterscheidet sich von der Kapazitätsmessschaltung 400 gemäß der Fig. 4a und der Kapazitätsmessschaltung 480 gemäß der Fig. 4b im Wesentlichen dadurch, dass eine gegenüber den Rückkopplungs-Ladungsbereitstellungsschaltungen 360, 482 veränderte Rückkopplungs-Ladungsbereitstellungsschaltung 492 zum Einsatz kommt, die abhängig von einem aktuellen Wert des digitalen Bitstroms 252 dem Ladungs-Summationsknoten 232 eine erste Rückkopplungs-Ladungsmenge oder eine zweite Rückkopplungs-Ladungsmenge zuführt, wobei die erste Rückkopplungs-Ladungsmenge und die zweite Rückkopplungs-Ladungsmenge typischerweise entgegengesetzte Vorzeichen aufweisen.

Die Rückkopplungs-Ladungsbereitstellungsschaltung 492 umfasst beispielsweise eine Spannungsquelle, die ein erstes zumindest näherungsweise sinusförmiges Signal 494a und ein zweites zumindest näherungsweise sinusförmiges Signal 494b bereitstellt. Das erste sinusförmige Signal 494a und das zweite sinusförmige Signal 494b können beispielsweise zueinander inverse bzw. zueinander um 180° phasenverschobene Signale sein. Das erste sinusförmige Signal 494a kann im Übrigen identisch zu dem sinusförmigen Signal 372 sein, und das zweite sinusförmige Signal 494b kann beispielsweise identisch zu dem sinusförmigen Signal 242 sein. Zueinander identische sinusförmige Signale können im Übrigen unter Verwendung der gleichen Spannungsquelle bereitgestellt werden.

Der Rückkopplungs-Ladungsbereitsteller 492 ist somit ausgelegt, um das erste sinusförmige Signal 494a an einen ersten Anschluss 495a einer ersten Rückkopplungskapazität Cfbanzulegen und um das zweite sinusförmige Signal 494b an einen ersten Anschluss einer zweiten Rückkopplungskapazität Cfb+ anzulegen.

Ein zweiter Anschluss 495b der ersten Rückkopplungskapazität Cfb- ist über einen ersten Schalter 496a alternativ mit einer Bezugspotentialzuführung für das Bezugspotential GND und einem ersten Anschluss eines dritten Schalters 497 koppelbar. Ein zweiter Anschluss 495b der zweiten Rückkopplungskapazität Cfb+ ist über einen zweiten Schalter 496b alternativ mit einer Bezugspotentialzuführung für das Bezugspotential GND und einem zweiten Anschluss des dritten Schalters 497 koppelbar. Bevorzugt wird der erste Schalter 496a so angesteuert, dass der zweite Anschluss 494b der ersten Rückkopplungskapazität Cfb- in der ersten Phase mit der Bezugspotentialzuführung für das Bezugspotential GND gekoppelt ist und in der zweiten Phase mit dem ersten Anschluss des dritten Schalters 497. In ähnlicher Weise wird der zweite Schalter 496b bevorzugt so angesteuert, dass der zweite Anschluss 495b der zweiten Rückkopplungskapazität Cfb+ in der ersten Phase mit der Bezugspotentialzuführung für das Bezugspotential GND gekoppelt ist und in der zweiten Phase mit dem zweiten Anschluss des dritten Schalters 497 gekoppelt ist. Der dritte Schalter 497 ist im Übrigen ausgelegt, um in Abhängigkeit von einem aktuellen Wert des digitalen Bitstroms 252 alternativ seinen ersten Anschluss oder seinen zweiten Anschluss mit dem Ladungs-Summationsknoten 232 zu koppeln.

Insgesamt sind somit in der ersten Phase der zweite Anschluss 495b der ersten Rückkopplungskapazität Cfb- und der zweite Anschluss 495b der zweiten Rückkopplungskapazität Cfb+ mit der Bezugspotentialzuführung für das Bezugspotential GND gekoppelt. In der zweiten Phase hingegen ist, abhängig von dem aktuellen Wert des digitalen Bitstroms 252, alternativ entweder der zweite Anschluss 495b der ersten Rückkopplungskapazität Cfb- oder der zweite Anschluss 495d der zweiten Rückkopplungskapazität Cfb+ mit dem Ladungs-Summationsknoten 232 gekoppelt.

Somit wird erreicht, dass auf die erste Rückkopplungskapazität Cfb- während der ersten Phase eine Ladungsmenge aufgebracht wird, die durch eine an dem ersten Anschluss 495a der ersten Rückkopplungskapazität Cfb- anliegende Spannung zu dem Ende der ersten Phase bestimmt wird. In ähnlicher Weise wird auch auf die zweite Rückkopplungskapazität Cfb+ während der ersten Phase eine Ladung aufgebracht, deren Größe durch eine an dem ersten Anschluss 495c der zweiten Rückkopplungskapazität Cfb+ anliegende Spannung zu dem Ende der ersten Phase bestimmt wird. Während der zweiten Phase wird dann die Ladungsmenge zumindest auf derjenigen der Rückkopplungskapazitäten Cfb-, Cfb+ verändert, deren zweiter Anschluss 495b, 495d mit dem Ladungs-Summationsknoten 232 gekoppelt ist. Die zum Ende der zweiten Phase auf der mit dem Ladungs-Summationsknoten 232 gekoppelten Rückkopplungskapazität gespeicherte Ladungsmenge wird durch die an dem ersten Anschluss 495a bzw. 495c der entsprechenden Kapazität anliegende Spannung zu dem Ende der zweiten Phase bestimmt, so dass insgesamt eine Veränderung der auf der entsprechenden Rückkopplungskapazität gespeicherten Ladungsmenge während der zweiten Phase durch eine Veränderung der Spannung an dem ersten Anschluss der entsprechenden Kapazität zwischen dem Ende der ersten Phase und dem Ende der zweiten Phase bestimmt wird. Somit ergibt sich eine Veränderung der auf der ersten Rückkopplungskapazität Cfb- bzw. der zweiten Rückkopplungskapazität Cfb+ gespeicherten Ladungsmenge zwischen dem Ende der ersten Phase und dem Ende der zweiten Phase. Diese Veränderung der gespeicherten Ladungsmenge hat zur Folge, dass dem Ladungs-Summationsknoten während der zweiten Phase eine Ladungsmenge von derjenigen Rückkopplungskapazität Cfb- bzw. Cfb+ zugeführt wird, deren zweiter Anschluss 495b, 495d während der zweiten Phase mit dem Ladungs-Summationsknoten 232 gekoppelt ist. Dabei ist es typischerweise so, dass die dem Ladungs-Summationsknoten 232 während der zweiten Phase zugeführte Ladungsmenge unterschiedliche Vorzeichen aufweist, je nachdem, welche der beiden Rückkopplungskapazitäten Cfb- bzw. Cfb+ in der zweiten Phase mit dem Ladungs-Summationsknoten gekoppelt ist.

Somit kann insgesamt erreicht werden, dass dem Ladungs-Summationsknoten 232 durch die Rückkopplungs-Ladungsbereitstellungsschaltung 492 abhängig von dem aktuellen Wert des digitalen Bitstroms 252 eine positive Ladungsmenge oder eine negative Ladungsmenge zugeführt wird. Weiterhin wird eine besonders gute elektromagnetische Verträglichkeit typischerweise dadurch erreicht, dass an dem ersten Anschluss 495a der ersten Rückkopplungskapazität bzw. an dem ersten Anschluss 495c der zweiten Rückkopplungskapazität jeweils sinusförmige Spannungssignale anliegen. Im Übrigen wird eine besonders gute Präzision der Kapazitätsmessschaltung dadurch erzielt, dass die Signalform des an dem ersten Anschluss 495a der ersten Rückkopplungskapazität anliegenden Spannungssignals im Wesentlichen einer Signalform des sinusförmigen Spannungssignals 372 entspricht, und dass eine Signalform des an dem ersten Anschluss 495c der zweiten Rückkopplungskapazität anliegenden Spannungssignals im Wesentlichen einer Signalform des Spannungssignals 242 entspricht.

*5. Funktionsweise der Schaltungen gemäß den Fig. 2, 3 und 4a, 4b und 4c*

Im Folgenden werden Details im Hinblick auf die Funktionsweise und auch die besonderen Vorteile der Schaltungen gemäß den Fig. 2, 3, 4a, 4b und 4c beschrieben.

Diesbezüglich sei darauf hingewiesen, dass die Kapazitätsmessschaltung 200 gemäß der Fig. 2 als eine kapazitive Messschaltung mit "Standard"-Sigma-Delta-Modulator angesehen werden kann. Die Kapazitätsmessschaltung 300 gemäß der Fig. 3 kann hingegen als eine kapazitive Messschaltung mittels "Sinus"-Sigma-Delta-Modulator angesehen werden. Die Kapazitätsmessschaltung 400 gemäß Fig. 4a, die Kapazitätsmessschaltung 480 gemäß Fig. 4b und die Kapazitätsmessschaltung 490 gemäß der Fig. 4c können ebenfalls als kapazitive Messschaltungen mittels "Sinus"-Sigma-Delta-Modulator angesehen werden.

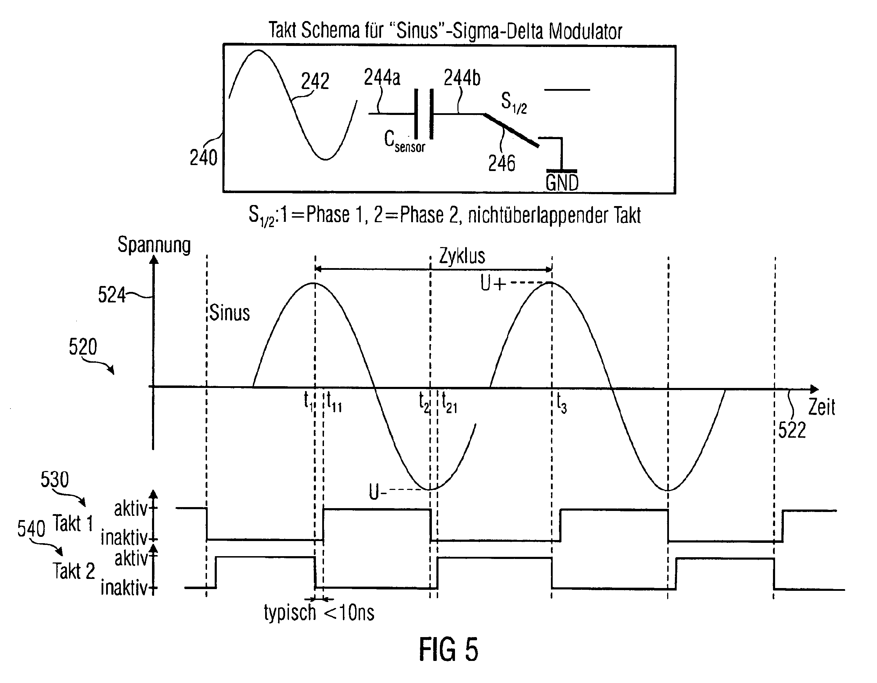

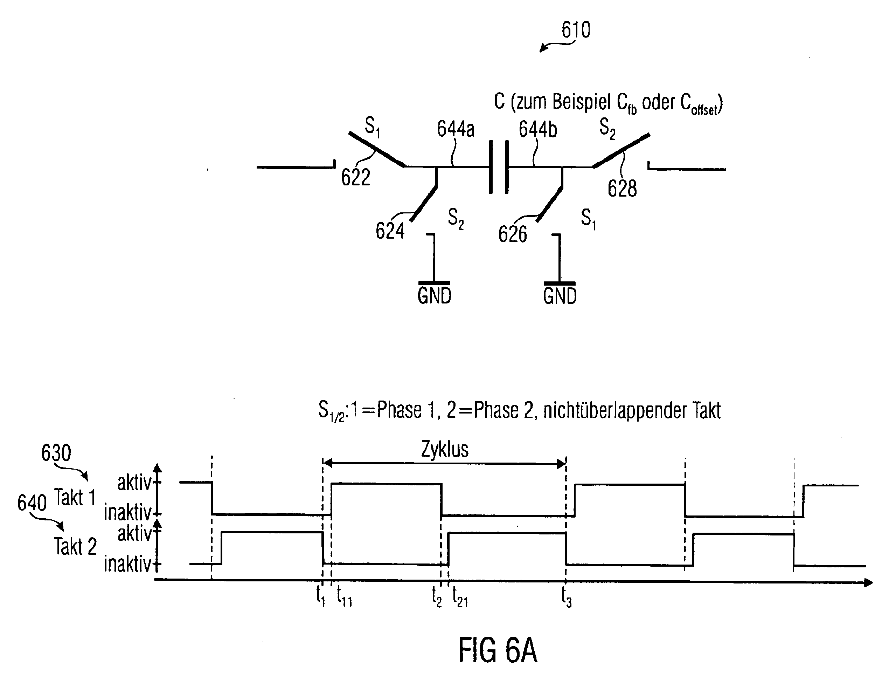

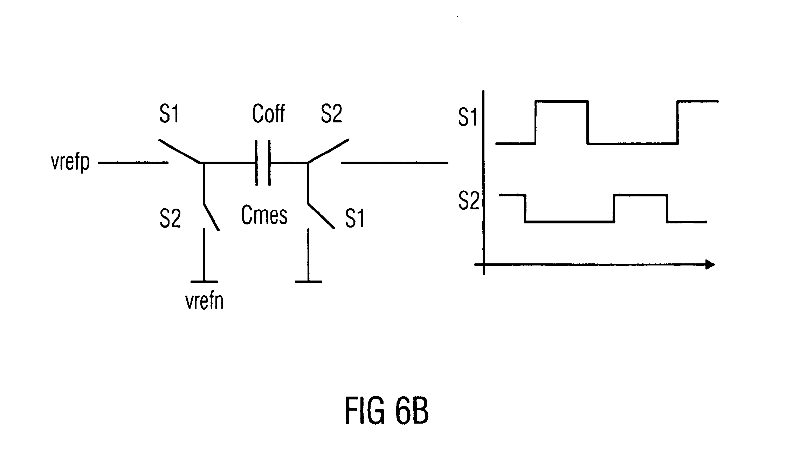

Im Folgenden wird anhand der Fig. 5, 6a und 6b das Taktschema der Kapazitätsmessschaltungen 200, 300, 400, 480, 490 beschrieben.

Fig. 5 zeigt ein Schaltbild der Messladungs-Bereitstellungsschaltung 240 sowie eine graphische Darstellung der an dem ersten Anschluss 244a der zu messenden Kapazität Csensor anliegenden Sinusspannung sowie der Schaltzustände des Umschalters 246. Eine schematische Darstellung 520 beschreibt den Verlauf der an dem ersten Anschluss 244a der zu messenden Kapazität Csensor anliegenden sinusförmigen Spannung über die Zeit, wobei eine Abszisse 522 die Zeit beschreibt und wobei eine Ordinate 524 den Spannungswert beschreibt. Zyklen des Delta-Sigma-Modulators sind typischerweise mit dem sinusförmigen Spannungssignal an dem ersten Anschluss 244a der zu messenden Kapazität Csensor zeitlich synchronisiert. Beispielsweise wird hier davon ausgegangen, dass ein erster Zyklus des Delta-Sigma-Modulators zu einem Zeitpunkt t1 beginnt, zu dem das Spannungssignal an dem Anschluss 244a der zu messenden Kapazität Csensor ein Maximum aufweist, und zu einem Zeitpunkt t3 endet, zu dem die Spannung an dem ersten Anschluss 244a ihr nächstes Maximum aufweist.

Es wird hier davon ausgegangen, dass zwei versetzte Taktsignale (Takt 1, Takt 2) bereitgestellt werden, die die unterschiedlichen Phasen bzw. Arbeitsphasen des Delta-Sigma-Modulators steuern. Ein zeitlicher Verlauf eines ersten Taktsignals "Takt 1" ist bei Bezugszeichen 530 gezeigt, und ein zeitlicher Verlauf eines zweiten Taktsignals "Takt 2" ist bei Bezugszeichen 540 gezeigt. Das erste Taktsignal (Takt 1) wird beispielsweise zu einem Zeitpunkt t11 aktiviert, der kurz nach dem Zeitpunkt t1 ist, zu dem das sinusförmige Spannungssignal an dem Anschluss 244a der zu messenden Kapazität Csensor sein Maximum aufweist. Das erste Taktsignal wird beispielsweise zu dem Zeitpunkt t2 deaktiviert, zu dem das sinusförmige Spannungssignal an dem ersten Anschluss 244a der zu messenden Kapazität Csensor sein Minimum aufweist. Das erste Taktsignal bleibt dann während des restlichen Zyklus, also zwischen den Zeitpunkten t2 und t3, inaktiv.

Das zweite Taktsignal (Takt 2) hingegen wird zu dem Zeitpunkt t1 inaktiv. Das zweite Taktsignal (Takt 2) wird zu dem Zeitpunkt t21, der kurz nach dem Zeitpunkt t2 liegt, aktiviert und bleibt dann bis zu dem Zeitpunkt t3 aktiv.

Somit sind das erste Taktsignal (Takt 1) und das zweite Taktsignal (Takt 2) nicht-überlappend, d. h. zu keinem Zeitpunkt beide gleichzeitig aktiv.

Im Übrigen sei darauf hingewiesen, dass eine Periodendauer des sinusförmigen Spannungssignals an dem Anschluss 244a der zu messenden Kapazität Csensor typischerweise in einem Bereich zwischen 100 Nanosekunden und 5 Mikrosekunden liegt, was einer Frequenz zwischen 200 kHz und 10 MHz entspricht. Ein Zeitintervall zwischen den Zeitpunkten t1 und t11 beträgt typischerweise weniger bzw. sogar deutlich weniger als 1/20 einer Periodendauer des entsprechenden Spannungssignals. Dasselbe gilt für ein Zeitintervall zwischen den Zeitpunkten t2 und t21. Im Übrigen ist das Zeitintervall zwischen den Zeitpunkten t1 und t11 bzw. das Zeitintervall zwischen den Zeitpunkten t2 und t21 typischerweise kürzer als 10 Nanosekunden, so dass die Zeiträume, zu denen sowohl das erste Taktsignal als auch das zweite Taktsignal inaktiv sind, sehr kurz sind.

Im Übrigen sei darauf hingewiesen, dass die erste Phase des Sigma-Delta-Modulators dadurch definiert ist, dass das erste Taktsignal aktiv ist. Die erste Phase des Sigma-Delta-Modulators erstreckt sich damit von dem Zeitpunkt t11 zu dem Zeitpunkt t2. Die zweite Phase des Sigma-Delta-Modulators ist im Übrigen dadurch definiert, dass das zweite Taktsignal aktiv ist. Die zweite Phase des Sigma-Delta-Modulators erstreckt sich somit von dem Zeitpunkt t21 bis zu dem Zeitpunkt t3.

Betrachtet man nun die Funktionsweise der Messladungs-Bereitstellungsschaltung 240, so wird ersichtlich, dass an dem ersten Anschluss 244a der zu messenden Kapazität Csensor zu dem Ende der ersten Phase eine Spannung U- anliegt, die beispielsweise dem (typischerweise negativen) Minimalwert des von der Messspannungsquelle gelieferten sinusförmigen Spannungssignals entspricht. Während der ersten Phase ist die zu messende Kapazität Csensor von dem Ladungs-Summationsknoten 232 durch den Schalter 246 getrennt.

Während der zweiten Phase hingegen wird die zu messende Kapazität Csensor umgeladen, so dass an dem Ende der zweiten Phase eine Spannung U+ an dem ersten Anschluss 244a der zu messenden Kapazität Csensor anliegt, wobei die Spannung U+ dem (typischerweise positiven) Maximalwert des von der Messspannungsquelle gelieferten sinusförmigen Spannungssignals entspricht. Der zweite Anschluss 244b der zu messenden Kapazität Csensor wird hingegen durch den Operationsverstärker 234 des Ladungsintegrators 230 auf dem Bezugspotential GND gehalten. Somit wird erreicht, dass ein Spannungsverlauf zwischen den Anschlüssen 244a, 244b bzw. den Elektroden der zu messenden Kapazität Csensor im Wesentlichen sinusförmig ist, und dass auch entsprechende Stromflüsse in jeweiligen Zuführungsleitungen, die mit den Anschlüssen 244a, 244b bzw. den Elektroden der zu messenden Kapazität gekoppelt sind, näherungsweise sinusförmig sind. Dies führt zu einer deutlichen Reduzierung von Störungen.

Im Folgenden wird anhand der Fig. 6 noch beschrieben, wie die Schalter-Kondensator-Technik, die zur Realisierung des Rückkopplungs-Ladungsbereitstellers 260 eingesetzt wird, und die bei der Kapazitätsmessschaltung 200 auch zur Realisierung des Offset-Ladungsbereitstellers 270 eingesetzt wird, funktioniert.

Fig. 6a zeigt bei Bezugszeichen 610 eine Prinzipschaltung der sogenannten Schalter-Kondensator-Technik. Die Schaltungsanordnung 610 kann beispielsweise die Funktion der Rückkopplungskapazität Cfb in Verbindung mit den Schaltern 262, 266 übernehmen.

Bei Bezugszeichen 630 ist eine graphische Darstellung der Zustände des ersten Taktsignals gezeigt und bei Bezugszeichen 640 ist eine graphische Darstellung der Zustände des zweiten Taktsignals gezeigt. Die Definition der verschiedenen Phasen innerhalb eines Zyklus entspricht der anhand der Fig. 5 bereits erläuterten Definition. Die Schaltungsanordnung 610 umfasst einen ersten eingangsseitigen Schalter 622, der angeordnet ist, um einen ersten Anschluss 644a der Kapazität C in der ersten Phase mit einer Spannungsquelle (nicht in Fig. 6a gezeigt) zu verbinden. Die Schaltungsanordnung 610 umfasst ferner einen zweiten eingangsseitigen Schalter 624, der ausgelegt ist, um den ersten Anschluss 644a der Kapazität C in der zweiten Phase mit einer Zuführung für das Bezugspotential GND zu verbinden. Die Schaltungsanordnung 610 umfasst ferner einen ersten ausgangsseitigen Schalter 626, der ausgelegt ist, um einen zweiten Anschluss 644b der Kapazität C in der ersten Phase mit der Zuführung für das Bezugspotential GND zu verbinden. Die Schaltungsanordnung 610 umfasst zudem einen zweiten ausgangsseitigen Schalter 628, der ausgelegt ist, um den zweiten Anschluss 644b der Kapazität C mit einem weiteren Schaltungsknoten, z. B. dem Ladungs-Summationsknoten 232, zu verbinden.

Der erste eingangsseitige Schalter 622 und der erste ausgangsseitige Schalter 626 werden beispielsweise durch das erste Taktsignal (Takt 1) angesteuert und sind somit in der ersten Phase geschlossen und ansonsten geöffnet. Der zweite eingangsseitige Schalter 624 und der zweite ausgangsseitige Schalter 628 werden beispielsweise durch das zweite Taktsignal (Takt 2) angesteuert und sind somit in der zweiten Phase geschlossen und ansonsten geöffnet. Somit wird die Kapazität C in der ersten Phase über die eingangsseitige Spannungsquelle geladen und in der zweiten Phase über den ausgangsseitigen Schalter 628 hin zu einem weiteren Knoten, z. B. dem Ladungs-Summationsknoten 232, entladen.

Somit wird die Kapazität C abwechselnd geladen und entladen, wobei die Ladephase (Phase 1) und die Entladephase (Phase 2) zeitlich nicht-überlappend sind.

Alternativ zu der Schaltungsanordnung 610 kann im Übrigen die zeitliche Ansteuerung der eingangsseitigen Schalter 622, 624 auch vertauscht sein, wie dies beispielsweise bei dem Rückkopplungs-Ladungsbereitsteller 260 der Fall ist. Während die Kapazität C hier geladen wird, ist die Kapazität in diesem Fall zwischen die in der Fig. 6a nicht gezeigte eingangsseitige Spannungsquelle und den in der Fig. 6a nicht gezeigten weiteren ausgangsseitigen Knoten (z. B. den Ladungs-Summationsknoten 232) geschaltet, so dass beim Aufladen der Kapazität C eine Ladung zu dem ausgangsseitigen Knoten (z. B. Ladungs-Summationsknoten 232) übertragen wird. In diesem Fall wird die Kapazität C über die dann gleichzeitig geschlossenen Schalter 624, 626 entladen.

Beide Varianten im Hinblick auf die Ansteuerung der Schalter 622, 624, 626 und 628 sind in Verbindung mit der oben beschriebenen Kapazitätsmessschaltung möglich und sinnvoll.

Fig. 6b zeigt eine weitere Darstellung des Prinzips der Schalter-Kondensator-Technik.

Im Hinblick auf die grundsätzliche Arbeitsweise der Kapazitätsmessschaltungen 200, 300, 400 gemäß den Fig. 2, 3, 4a, 4b und 4c ist festzuhalten, dass zwischen einer Ladung Qint auf der Integrationskapazität Cint, einer Ladung Qmess, die von der Sensorkapazität Csensor auf die Integrationskapazität Cint übertragen wird, der Offset-Ladung Qoff, die von der Offset-Kapazität Coffset auf die Integrationskapazität Cint übertragen wird, und der Rückkopplungskapazität Cfb, die von der Rückkopplungskapazität Cfb auf die Integrationskapazität Cint übertragen wird, bei geeigneter Definition der Vorzeichen der Ladungen, der folgende Zusammenhang gilt:

$$Qint = Qmess - (Qoff + Qfb).$$

Auf der Integrationskapazität wird gleichzeitig (oder, alternativ, in einer bestimmten Sequenz) die Ladung der Messkapazität, der Offset-Kapazität und der Rückkopplungskapazität aufgebracht.

Bei einem bevorzugten Ausführungsbeispiel gilt, dass ein Kapazitätswert Cfb der Rückkopplungskapazität größer oder gleich einer Differenz zwischen den Kapazitätswerten der zu messenden Kapazität (Cmess) und der Offset-Kapazität (Coff) ist:

$$Cfb \geq (Cmess - Coff).$$

Bei einigen bevorzugten Ausführungsbeispielen gilt weiterhin:

$$Cmess > Cfb.$$

Bei einem bevorzugten Ausführungsbeispiel gilt:

$$Cmess = 2 * Cfb.$$

Die Kapazitätsmessschaltungen 200, 300, 400 gemäß den Fig. 2, 3, 4a, 4b und 4c arbeiten bevorzugt mit nicht-überlappenden Zwei-Phasen-Takten konstanter Frequenz. In der ersten Taktphase werden die Schalter 1 geschlossen und die Kapazitäten Cmess (bzw. Csensor), Coff und Cfb aufgeladen. In der zweiten Taktphase werden die Schalter 2 geschlossen und es werden die Ladungen aller drei Kapazitäten auf die Integrationskapazität Cint gegeben.

Fig. 6b zeigt eine mögliche Schaltervariante mit dem zugehörigen Taktdiagramm. Es gibt allerdings viele weitere Schaltungsvarianten für die Schalter-Kondensator-Technik (englisch: switched capacitor technique).

Ganz allgemein ist im Übrigen anzumerken, dass bei Schaltungsanordnungen, bei denen mehrere sinusförmige Spannungen verwendet werden, die an verschiedenen Eingängen des Modulators anliegen, Amplituden der sinusförmigen Spannungen unterschiedlich gewählt werden können. Dies gilt beispielsweise für die Schaltungsanordnung 300 gemäß Fig. 3, wobei die Amplituden der an den Kondensator-Anschlüssen 244a, 374a anliegenden sinusförmigen Spannungen 242, 372 unterschiedlich gewählt sein können. Ebenso gilt dies beispielsweise für die Schaltungsanordnung 400 gemäß Fig. 4a, wobei die Amplituden der an den Kondensator-Anschlüssen 444a, 474a anliegenden sinusförmigen Spannungen 242, 372 unterschiedlich gewählt sein können, für die Schaltungsanordnung 480 gemäß Fig. 4b, wobei die Amplituden der an den Kondensator-Anschlüssen 444a, 474a, 485a anliegenden sinusförmigen Spannungen 242, 372, 484 unterschiedlich gewählt sein können, und für die Schaltungsanordnung 490 gemäß Fig. 4c, wobei die Amplituden der an den Kondensator-Anschlüssen 444a, 474a, 495a, 495c anliegenden sinusförmigen Spannungen 242, 372, 494a, 494b unterschiedlich gewählt sein können. Auch die jeweiligen Kapazitäten können dann unterschiedlich gewählt sein.

Ein Teilaspekt der hier beschriebenen Schaltungsanordnung besteht also darin, dass Amplituden der Sinusspannungen an den verschiedenen Eingängen des Modulators(zum Beispiel bei der Schaltungsanordnung gemäß Fig. 4a) nicht die gleiche Amplitude haben müssen, sondern auch verwendet werden können, um das Verhältnis der Messladung, der Offsetladung und der Rückkopplungsladung einzustellen.

Weiterhin sei darauf hingewiesen, dass in der vorliegenden Beschreibung der Schaltungsanordnungen eine asymmetrische (englisch: "single-ended") Realisierung bzw. Ausführung beschrieben bzw. dargestellt ist. Bei einer Implementierung bietet sich jedoch in manchen Fällen eine differentielle Ausführung an. In anderen Worten, sämtliche hierin beschriebenen Ausführungsbeispiele können alternativ auch differentiell realisiert werden. Der Übergang von der asymmetrischen ("single-ended") Schaltungstechnik zur differentiellen Schaltungstechnik ist dem Fachmann geläufig.

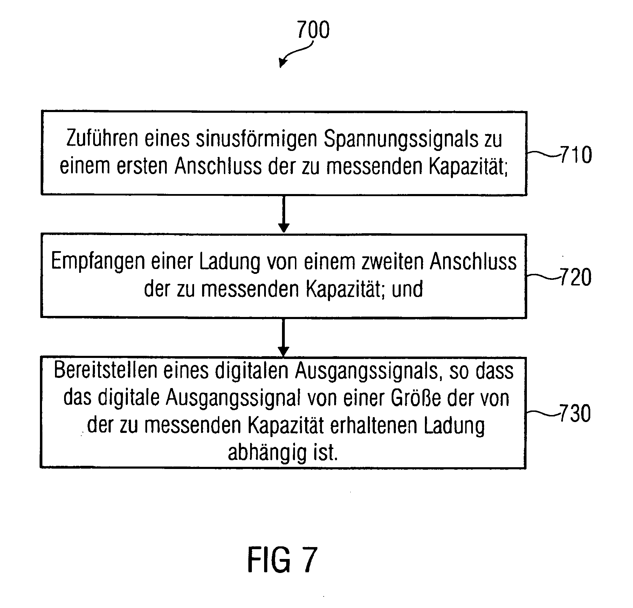

*6. Verfahren gemäß Fig. 7*

Fig. 7 zeigt ein Flussdiagramm eines Verfahrens zum Bestimmen eines Kapazitätswerts einer zu messenden Kapazität, gemäß einem Ausführungsbeispiel der vorliegenden Erfindung. Das Verfahren 700 umfasst in einem Schritt 710 ein Zuführen eines sinusförmigen Spannungssignals zu einem ersten Anschluss der zu messenden Kapazität. Das Verfahren 700 umfasst ferner in einem zweiten Schritt 720 ein Empfangen einer Ladung von einem zweiten Anschluss der zu messenden Kapazität. Das Verfahren 700 umfasst ferner in einem Schritt 730 ein Bereitstellen eines digitalen Ausgangssignals, so dass das digitale Ausgangssignal von einer Größe der von der zu messenden Kapazität erhaltenen Ladung abhängig ist.

Das Verfahren 700 kann um all diejenigen Merkmale und Funktionalitäten ergänzt werden, die hierin auch im Hinblick auf die erfindungsgemäße Vorrichtung beschrieben wurden.

*7. Schlussfolgerungen*

Im Folgenden wird das erfindungsgemäße Konzept noch einmal kurz zusammengefasst und es wird auf einige wichtige Aspekte eingegangen.

Ausführungsbeispiele der Erfindung betreffen die Verwendung eines Delta-Sigma-Modulators für die Kapazitätsmessung mit schmalbandiger Störabstrahlung. Damit kann man mögliche Störfrequenzen in Bereiche verschieben, die, je nach Anwendung, sich weniger kritisch auf die Umgebung auswirken. Darüber hinaus besteht die Möglichkeit, durch externe Beschaltungen diese schmalen Frequenzbänder einfacher zu unterdrücken, was bei einer breitbandigen Einkopplung, wie sie bei den bisher verwendeten Delta-Sigma-Verfahren angewendet wird, nicht möglich ist.

Die prinzipielle Funktion des Delta-Sigma-Modulators ist in Fig. 8 dargestellt. In anderen Worten, Fig. 8 zeigt eine schematische Darstellung des Prinzips des Delta-Sigma-Modulators.

Fig. 9 und 10 zeigen die Beschaltung bei Verwendung eines herkömmlichen Delta-Sigma-Modulators für die Kapazitätsmessung. Die Kapazität Cin am Eingang des Modulators wird in der ersten Taktphase aus der zu messenden Eingangsspannung vin geladen. Die Ladung wird in der zweiten Taktphase auf die Integrationskapazität Cint gegeben und entsprechend dem herkömmlichen Delta-Sigma-Prinzip weiterverarbeitet.

Ausführungsbeispiele gemäß der Erfindung schaffen ein System, bei dem die Eingangsspannung vin (wie sie beispielsweise bei den Schaltungsanordnungen 900 bzw. 1000 gemäß den Fig. 9 und 10 zum Einsatz kommt) durch eine frequenz- und amplitudenstabile Sinusspannung und die Kapazität Cin im Eingangszweig durch die Messkapazität Csensor ersetzt wird. Entsprechende Schaltungsanordnungen sind beispielsweise in den Fig. 1, 2, 3 4a, 4b und 4c gezeigt.

Auf die Sensorkapazität (beispielsweise auf den ersten Anschluss 244a der zu messenden Kapazität Csensor) wird ein Sinussignal (z. B. ein - zumindest näherungsweise - sinusförmiges Spannungssignal) anstatt (wie in bisherigen Veröffentlichungen) einem Rechtecksignal gegeben, und es wird somit eine breitbandige Störabstrahlung vermieden.

Die Kapazität Csensor ist gleichzeitig die Eingangskapazität (entsprechend Cin in den Schaltungen 900, 1000 gemäß den Fig. 9 und 10) des Delta-Sigma-Modulators.

Der Modulator arbeitet im Allgemeinen mit einer festen Arbeitsfrequenz, die aber von Messung zu Messung (optional) variiert werden kann.

Die Messkapazität Csensor wird bei Ausführungsbeispielen gemäß der Erfindung über die Schalter S1/x sukzessive aus einer definierten Sinusspannung geladen. Die Ladung wird anschließend über die Schalter Sx/2 auf die Integrationskapazitäten (bzw. die Integrationskapazität) des Modulators (z. B. Cint) gegeben, integriert und ausgewertet.

Die Schalter (beispielsweise die Schalter 246, 262, 266, 272, 276) werden mit einem nicht-überlappenden Zwei-Phasen-Takt mit fester Frequenz betrieben. Der Zwei-Phasen-Takt arbeitet synchron mit der am Eingang (z. B. am ersten Anschluss 244a) der Sensorkapazität anliegenden Sinusspannung "+ Sinus".

Der Ausgangsbitstrom (z. B. der digitale Bitstrom 252) wird aufintegriert bzw. einem digitalen Filter zugeführt, um so beispielsweise eine Information über einen Kapazitätswert der Kapazität zu erhalten.

Die optionale Offset-Kapazität Coffset hat bei einigen Ausführungsbeispielen eine um 180 Grad zum Eingangssinussignal (z. B. dem an dem ersten Anschluss 244a der Sensorkapazität Csensor anliegenden sinusförmigen Spannungssignal) verschobene Sinusspannung oder eine feste Spannung (z. B. vrefp oder vrefn).

Der Messbereich des Modulators wird bestimmt durch das Verhältnis der Kapazität Cfb im Rückkopplungszweig zur Eingangskapazität Cin sowie durch das Verhältnis der Sinussignalamplitude (beispielsweise des an dem ersten Anschluss 248a der zu messenden Kapazität Csensor anliegenden sinusförmigen Spannungssignals) zur Referenzspannung (vrefp - vrefn) im Rückkopplungszweig.

Prinzipiell kann der Rückkopplungszweig bei einigen Ausführungsbeispielen auch mit einer Sinusspannung versorgt werden.

Wird eine definierte Ladung von der Integrationsladung abgezogen, kann von der Messkapazität (Csensor) ein fester Offset-Anteil abgezogen werden. Dies kann durch eine Offset-Kapazität Coff parallel zur Sensorkapazität realisiert werden, die beispielsweise aus einer um 180 Grad verschobenen Sinusspannung (um 180 Grad verschoben in Bezug auf die an dem ersten Anschluss 244a der zu messenden Kapazität Csensor anliegende Sinusspannung) oder aus einer (festen oder umschaltbaren) Referenzspannung, vergleichbar dem Rückkopplungszweig, geladen wird.

Durch eine Variation der Amplitude der Sinusspannungen kann unter anderem die Empfindlichkeit der Messung, die Stärke der Störabstrahlung und auch die Offset-Ladung bezogen auf die Sensorladung beeinflusst werden.

Bei einigen Ausführungsbeispielen gemäß der vorliegenden Erfindung gilt zumindest näherungsweise:

$$Csensor = Cfb + Coffset.$$

Dabei gelten die folgenden Definitionen:

Cfb: Kapazität im Rückkopplungszweig (englisch: "feed back" = Rückkopplung);

Coffset: statischer Anteil der Messkapazität; und

Csensor: dynamischer Anteil der Messkapazität.

Es gibt verschiedene Möglichkeiten, die Offset-Kapazität zu realisieren, zum Beispiel:

- integrierte Siliziumkapazität;

- externe Offset-Kapazität Coffset; oder

- integrierter oder externer Kapazität-Digital-zu-Analog-Converter.

Im Gegensatz zu Standard-Sigma-Delta-Modulatoren soll der Takt bei dem hier vorgestellten Verfahren synchron zu dem Sinussignal (beispielsweise dem an dem ersten Anschluss 244a der zu messenden Kapazität Csensor anliegenden sinusförmigen Spannungssignal) sein. Für Details diesbezüglich sei auf die Fig. 5 und die entsprechenden Erläuterungen verwiesen. Die Umschaltung der einzelnen Phasen (z. B. Phase 1 bzw. Phase 2) der beiden Takte (Takt 1 und Takt 2) erfolgt jeweils bevorzugt im Maximum bzw. Minimum des Sinussignals. Auf der einen Platte bzw. Elektrode der Messkapazität (z. B. auf derjenigen Platte bzw. Elektrode, die mit dem ersten Anschluss 244a verbunden ist) liegt somit immer (zumindest während einer Kapazitätsmessung, die typischerweise mehrere Zyklen des Sigma-Delta-Wandlers umfasst) eine konstante Sinusfrequenz (bzw. ein stationäres sinusförmiges Spannungssignal) an und auf der zweiten Platte bzw. Elektrode (z. B. auf der mit dem zweiten Anschluss 244b verbundenen Platte bzw. Elektrode der zu messenden Kapazität Csensor) eine konstante Gleichspannung bzw. DC-Spannung. Die Sinusfrequenz kann bei einigen Ausführungsbeispielen von Messung zu Messung variiert werden, kann aber auch zwischen verschiedenen Messungen unverändert bleiben.

Wenn es notwendig oder wünschenswert ist, auch die Störabstrahlung der Offset-Kapazität zu minimieren, so kann diese entsprechend den Ausführungsbeispielen gemäß den Fig. 3 und 4 beispielsweise mit einer um 180 Grad phasenverschobenen Sinusspannung (phasenverschoben im Hinblick auf die an dem ersten Anschluss der zu messenden Kapazität anliegende Sinusspannung) betrieben werden. Dadurch ist auf der Offset-Kapazität ebenfalls nur eine schmalbandige Abstrahlung gegeben.

Verwendet man eine Schaltung entsprechend den Fig. 4a, 4b oder 4c, so sollte die Eingangsspannung (die an dem ersten Anschluss 274a der Offset-Kapazität Coff anliegt) eine um 180 Grad zum Eingangssignal (der an dem ersten Anschluss 444a der zu messenden Kapazität Csensor anliegenden Spannung) phasenverschobene Sinusspannung sein. Alternativ zur Sinusspannung kann auch ein Sinusstrom (z. B. zur Bereitstellung einer Offset-Ladung) verwendet werden. Alle restlichen Schaltungskomponenten bleiben gleich.

Die Synchronisation von Sinusspannung und Takt ist durch verschiedene Möglichkeiten zu erreichen. So kann ausgehend von einer Sinusspannung der zugehörige Takt durch eine Nullpunkt- und/oder Min-/Max-Spannungserkennung erfolgen. Eine andere bevorzugte Implementierung verwendet einen n-fach höheren Oszillatortakt und generiert über digitale Stützstellen und einen Digital-Analog-Umsetzer eine sinusförmige Signalform, die mit einem Tiefpassfilter geglättet werden kann. Diese und ähnliche Verfahren zur Synchronisation einer Sinusspannung mit einem digitalen Takt sind allgemein bekannt.

Im Folgenden wird eine Beurteilung der erfindungsgemäßen Schaltungsanordnung erörtert. Zunächst werden wesentliche Vorteile von Ausführungsbeispielen gemäß der Erfindung beschrieben.

Ein wesentlicher Vorteil von Ausführungsbeispielen gemäß der vorliegenden Erfindung liegt in der Kombination der Vorteile kapazitiver Delta-Sigma-Modulatoren mit einer schmalbandigen Sensoranregung, wie sie auch in Synchrondemodulatoren verwendet wird. Die Störabstrahlung ist auf ein einstellbares schmales Frequenzband begrenzt. Deshalb kann bei entsprechender Frequenzwahl das Sensoranregungssignal mit hoher Amplitude appliziert werden. Dadurch wird z. B. bei der Verwendung des Verfahrens für Näherungssensoren, Abstandssensoren und andere Sensoren der Wirkungsabstand vergrößert.

Das erfindungsgemäße Konzept stellt somit eine vorteilhafte Alternative zur Verwendung von synchronen Demodulatoren dar. Anders als bei synchronen Demodulatoren, die als Ausgangssignal eine analoge Spannung liefern, die erst mit einem weiteren Schaltungsblock in ein digitales Signal umgesetzt werden muss, liefert ein Delta-Sigma-Modulator mit geringem Schaltungsaufwand unmittelbar ein digitales Ausgangssignal, beispielsweise in Form des digitalen Bitstroms 252.

Im Folgenden werden noch einige Anwendungsgebiete des Erfindungskonzepts beschrieben.

Die erfindungsgemäße Kapazitätsmessschaltung bzw. ein erfindungsgemäßes Sensorsystem bzw. ein erfindungsgemäßes Verfahren eignet sich besonders bei allen kapazitiven Messsystemen, bei denen der Sensor kein geschirmtes System darstellt, sondern seine Sensorwirkung über das abgestrahlte Feld erreicht:

- Einklemmschutz bei automatisch sich schließenden Fenstern, Türen und anderen Bauteilen;

- Überwachung von Robotern oder anderen bewegten Teilen gegen Zusammenprall mit Personen oder Objekten;

- Verfahren zur Messung von Materialparametern, Dicke, Konsistenz, Wassergehalt usw. in offenen Messsystemen;

- Feuchte- und Regensensoren; und

- berührungsempfindliche bzw. berührungssensitive Bedien- und Eingabefelder.

Ausführungsbeispiele gemäß der Erfindung können im Zusammenhang mit all denjenigen Anwendungen eingesetzt wurden, die hierin, auch in dem einleitenden Abschnitt, beschrieben wurden.

Zusammenfassend ist somit festzuhalten, dass Ausführungsbeispiele gemäß der Erfindung eine Messung von Kapazitäten mit Delta-Sigma-Modulatoren mit schmalbandiger Störabstrahlung betreffen. Während herkömmliche kapazitive Messverfahren mit Delta-Sigma-Modulatoren, auch bekannt unter dem Begriff "Kapazitäts-zu-digital-Konverter" ("CDC"), üblicherweise mit rechteckigen oder quasi-rechteckigen Signalen auf der zu messenden Kapazität arbeiten, wird bei Ausführungsbeispielen gemäß der Erfindung ein sinusförmiges Spannungssignal an die zu messende Kapazität angelegt. Es wurde herausgefunden, dass das Vorhandensein von rechteckigen oder quasi-rechteckigen Signalen auf der zu messenden Kapazität bei offenen Sensorsystemen zu erheblichen Problemen mit Störabstrahlung führen. Das erfindungsgemäße Konzept bzw. Verfahren hingegen arbeitet mit einem Sinussignal auf der Sensorkapazität und begrenzt damit die Störabstrahlung auf ein definiertes schmales Frequenzband.

Ausführungsbeispiele gemäß der Erfindung können beispielsweise als integrierte Schaltungen implementiert sein. Eine Realisierung kann aber genauso gut auch mit diskreten Bauteilen erfolgen.

Die Implementierung kann sowohl asymmetrisch, wie oben im Detail beschrieben, als auch symmetrisch erfolgen

Ausführungsbeispiele gemäß der vorliegenden Erfindung sind im Bereich der kapazitiven Messtechnik universell einsetzbar. Ausführungsbeispiele gemäß der Erfindung stellen somit eine wesentliche Verbesserung des Konzepts gemäß der DE 10 2005 038 875 A1 dar.

Ein Beispiel schafft eine Kapazitätsmessschaltung 100; 200; 300; 400 mit einer Messspannungsquelle 110, die ausgelegt ist, um einem ersten Anschluss 120a; 244a; 444a einer zu messenden Kapazität Cmess, Csensor ein sinusförmiges Spannungssignal 242 zuzuführen, um eine zeitliche Änderung einer in der zu messenden Kapazität gespeicherten Ladung zu bewirken; und mit einem Delta-Sigma-Modulator 130; 230, Csensor, 246, 250, 260, 270, wobei der Delta-Sigma-Modulator ausgelegt ist, um von einem zweiten Anschluss 120b; 244b; 444b der zu messenden Kapazität eine Ladung zu erhalten und um ein digitales Ausgangssignal 132; 252 bereitzustellen, das von einer Größe der von der zu messenden Kapazität erhaltenen Ladung abhängig ist; wobei die Kapazitätsmessschaltung ausgelegt ist, um die zu messende Kapazität Cmess, Csensor in einer ersten Phase unter Verwendung des sinusförmigen Spannungssignals 242 in einen ersten Aufladungszustand zu bringen, und um die zu messende Kapazität in einer zweiten Phase unter Verwendung des sinusförmigen Spannungssignals 242 in einen zweiten Aufladungszustand zu bringen; und wobei der Delta-Sigma-Modulator 130; 230, Csensor, 246, 250, 260, 270 ausgelegt ist, um eine Ladungsmenge, die gleich einem Unterschied zwischen einer auf der zu messenden Kapazität Cmess, Csensor in dem ersten Aufladungszustand gespeicherten Ladungsmenge und einer auf der zu messenden Kapazität in dem zweiten Aufladungszustand gespeicherten Ladungsmenge ist, zu empfangen und um das digitale Ausgangssignal 132; 252 in Abhängigkeit von der empfangenen Ladungsmenge bereitzustellen.

Bei einem Beispiel der Kapazitätsmessschaltung 100; 200; 300; 400 ist die Messspannungsquelle 110 ausgelegt, um während einer Kapazitätsmessung der zu messenden Kapazität Cmess; Csensor ein frequenzstabiles und amplitudenstabiles sinusförmiges Spannungssignal 242 zuzuführen.

Bei einem Beispiel der Kapazitätsmessschaltung 100; 200; 300; 400 ist die Messspannungsquelle ausgelegt, um das frequenzstabile und amplitudenstabile sinusförmige Spannungssignal 242 zumindest drei Perioden lang ununterbrochen dem ersten Anschluss 120a; 244a; 444a der zu messenden Kapazität zuzuführen.

Bei einem Beispiel der Kapazitätsmessschaltung 100; 200; 300; 400 ist die Kapazitätsmessschaltung ausgelegt, um an der zu messenden Kapazität Cmess, Csensor einen periodischen Spannungsverlauf zu erzeugen, so dass sich Spannungswerte an der zu messenden Kapazität von Spannungswerten eines sinusförmigen Spannungsverlaufs während einer Periode um höchstens 10%, bezogen auf eine Amplitude des sinusförmigen Spannungsverlaufs, unterscheiden.

Bei einem Beispiel der Kapazitätsmessschaltung 100; 200; 300; 400 ist die Kapazitätsmessschaltung so ausgelegt, dass das von der Messspannungsquelle 100 bereitgestellte sinusförmige Spannungssignal 242 mit Arbeitsphasen des Delta-Sigma-Modulators synchronisiert ist.

Bei einem Beispiel der Kapazitätsmessschaltung 100; 200; 300; 400 ist der Delta-Sigma-Modulator ausgelegt, um einen Übergang zwischen einer ersten Phase, während der der zweite Anschluss 120b; 244b;

444b der zu messenden Kapazität Cmess; Csensor von einer Integrationskapazität Cint des Delta-Sigma-Modulators getrennt ist, und einer zweiten Phase, während der der zweite Anschluss der zu messenden Kapazität mit der Integrationskapazität des Delta-Sigma-Modulators gekoppelt ist, zur Zeit eines Maximums oder eines Minimums des sinusförmigen Spannungssignals 242 vorzunehmen.

Bei einem Beispiel der Kapazitätsmessschaltung 100; 200; 300; 400 weist der Delta-Sigma-Modulator einen Ladungsintegrator 230 mit einem eingangsseitigen Ladungs-Summationsknoten 232 und einem Integrationsergebnisausgang 233 auf, wobei der Ladungsintegrator ausgelegt ist, um eine an dem eingangsseitigen Ladungs-Summationsknoten empfangene Ladung aufzuintegrieren, um das Signal an dem Integrationsergebnisausgang zu erhalten; wobei der Delta-Sigma-Modulator ferner einen Schwellwertvergleicher 250 aufweist, der ausgelegt ist, um einen an dem Integrationsergebnisausgang 233 des Ladungsintegrators anliegenden Pegel, der ein Integral der an dem Ladungs-Summationsknoten empfangenen Ladung beschreibt, mit einem Schwellwert zu vergleichen und abhängig von einem Ergebnis des Vergleichs einen diskreten Wert des digitalen Ausgangssignals 132; 252 bereitzustellen; und wobei der Delta-Sigma-Modulator ausgelegt ist, um an dem Ladungs-Summationsknoten 232 eine Ladung von dem zweiten Anschluss 120b; 244b; 444b der zu messenden Kapazität Cmess, Csensor zu empfangen und zusätzlich eine von dem Ergebnis des Vergleichs abhängige Ladungsmenge Qfb zu dem Ladungs-Summationsknoten zuzuführen.

Bei einem Beispiel der Kapazitätsmessschaltung 100; 200; 300; 400 ist der Delta-Sigma-Modulator ausgelegt, um dem Ladungs-Summationsknoten in einer Phase des Delta-Sigma-Modulators eine vorbestimmte Ladungsmenge Qoffset zuzuführen, die eine von der zu messenden Kapazität Cmess; Csensor empfangene Ladungsmenge zumindest teilweise kompensiert.

Bei einem Beispiel der Kapazitätsmessschaltung 100 ist der Delta-Sigma-Modulator ausgelegt, um dem Ladungs-Summationsknoten 232 zumindest einen Ausschnitt aus einem sinusförmigen Stromverlauf zuzuführen.

Bei einem Beispiel der Kapazitätsmessschaltung ist die Kapazitätsmessschaltung in differentieller Schaltungstechnik ausgeführt.

## Patentansprüche

1.  Kapazitätsmessschaltung (100; 200; 300; 400) mit folgenden Merkmalen:

    einer Messspannungsquelle (110), die ausgelegt ist, um einem ersten Anschluss (120a; 244a; 444a) einer zu messenden Kapazität (Cmess, Csensor) ein sinusförmiges Spannungssignal

(242) zuzuführen, um eine zeitliche Änderung einer in der zu messenden Kapazität gespeicherten Ladung zu bewirken; und
    einem Delta-Sigma-Modulator (130; 230, Csensor, 246, 250, 260, 270), wobei der Delta-Sigma-Modulator ausgelegt ist, um von einem zweiten Anschluss (120b; 244b; 444b) der zu messenden Kapazität eine Ladung zu erhalten und um ein digitales Ausgangssignal (132; 252) bereitzustellen, das von einer Größe der von der zu messenden Kapazität erhaltenen Ladung abhängig ist;
    wobei die Kapazitätsmessschaltung ausgelegt ist, um die zu messende Kapazität (Cmess, Csensor) in einer ersten Phase unter Verwendung des sinusförmigen Spannungssignals (242) in einen ersten Aufladungszustand zu bringen, und um die zu messende Kapazität in einer zweiten Phase unter Verwendung des sinusförmigen Spannungssignals (242) in einen zweiten Aufladungszustand zu bringen; und
    wobei der Delta-Sigma-Modulator (130; 230, Csensor, 246, 250, 260, 270) ausgelegt ist, um eine Ladungsmenge, die gleich einem Unterschied zwischen einer auf der zu messenden Kapazität (Cmess, Csensor) in dem ersten Aufladungszustand gespeicherten Ladungsmenge und einer auf der zu messenden Kapazität in dem zweiten Aufladungszustand gespeicherten Ladungsmenge ist, zu empfangen und um das digitale Ausgangssignal (132; 252) in Abhängigkeit von der empfangenen Ladungsmenge bereitzustellen.

2.  Kapazitätsmessschaltung (100; 200; 300; 400) gemäß Anspruch 1, wobei der Delta-Sigma-Modulator eine Integrationskapazität (Cint) aufweist, und wobei der Delta-Sigma-Modulator ausgelegt ist, um den zweiten Anschluss (120b; 244b; 444b) der zu messenden Kapazität (Cmess, Csensor) in der ersten Phase von der Integrationskapazität zu trennen, so dass eine Ladung auf der Integrationskapazität von einer Veränderung der auf der zu messenden Kapazität gespeicherten Ladung während der ersten Phase unbeeinflusst bleibt; und wobei der Delta-Sigma-Modulator ausgelegt ist, um den zweiten Anschluss der zu messenden Kapazität in der zweiten Phase mit der Integrationskapazität zu koppeln, so dass eine Ladung auf der Integrationskapazität in der zweiten Phase durch eine während der zweiten Phase erfolgende Veränderung der auf der zu messenden Kapazität gespeicherten Ladung beeinflusst wird.

3.  Kapazitätsmessschaltung (100; 200; 300; 400) gemäß einem der Ansprüche 1 bis 2, wobei der Delta-Sigma-Modulator ausgelegt ist, um den zweiten Anschluss (120b; 244b; 444b) der zu messenden Kapazität, von Übergangsphasen, während derer der zweite Anschluss der zu messenden Kapazität in einem elektrisch schwebenden Zustand ist, abgesehen, auf ein vorgegebenes konstantes Potential (GND) zu ziehen.

4. Kapazitätsmessschaltung (100; 200; 300; 400) gemäß einem der Ansprüche 1 bis 3, wobei der Delta-Sigma-Modulator ausgelegt ist, um den zweiten Anschluss (120b; 244b; 444b) der zu messenden Kapazität in einer ersten Phase mit einer Bezugspotentialzuführung für ein Bezugspotential (GND) zu verbinden, und um den zweiten Anschluss der zu messenden Kapazität in einer zweiten Phase mit einem Virtuelle-Masse-Knoten, der auf das Bezugspotential gezogen wird, zu verbinden und eine Änderung der auf der zu messenden Kapazität gespeicherten Ladung während der zweiten Phase zu erfassen.

5. Kapazitätsmessschaltung (100; 200; 300; 400) gemäß einem der Ansprüche 1 bis 4, wobei der Delta-Sigma-Modulator einen Ladungsintegrator (230) mit einem eingangsseitigen Ladungs-Summationsknoten (232) und einem Integrationsergebnisausgang (233) aufweist, wobei der Ladungsintegrator ausgelegt ist, um eine an dem eingangsseitigen Ladungs-Summationsknoten empfangene Ladung aufzuintegrieren, um das Signal an dem Integrationsergebnisausgang zu erhalten;
wobei der Delta-Sigma-Modulator ferner einen Schwellwertvergleicher (250) aufweist, der ausgelegt ist, um einen an dem Integrationsergebnisausgang (233) des Ladungsintegrators anliegenden Pegel, der ein Integral der an dem Ladungs-Summationsknoten empfangenen Ladung beschreibt, mit einem Schwellwert zu vergleichen und abhängig von einem Ergebnis des Vergleichs einen diskreten Wert des digitalen Ausgangssignals (132; 252) bereitzustellen; und
wobei der Delta-Sigma-Modulator ausgelegt ist, um an dem Ladungs-Summationsknoten (232) eine Ladung von dem zweiten Anschluss (120b; 244b; 444b) der zu messenden Kapazität (Cmess, Csensor) zu empfangen und zusätzlich eine von dem Ergebnis des Vergleichs abhängige Ladungsmenge (Qfb) zu dem Ladungs-Summationsknoten zuzuführen.

6. Kapazitätsmessschaltung (100; 200; 300; 400) gemäß Anspruch 5, wobei der Delta-Sigma-Modulator ausgelegt ist, um dem Ladungs-Summationsknoten in einer Phase des Delta-Sigma-Modulators eine vorbestimmte Ladungsmenge (Qoffset) zuzuführen, die eine von der zu messenden Kapazität (Cmess; Csensor) empfangene Ladungsmenge zumindest teilweise kompensiert, und wobei der Delta-Sigma-Mbdulator eine Offset-Kapazität (Coffset; Coff) mit einem ersten Anschluss (274a; 374; 474a) und einem zweiten Anschluss (274b; 374b; 474b) aufweist, wobei der Delta-Sigma-Modulator ausgelegt ist, um an dem ersten Anschluss der Offset-Kapazität ein sinusförmiges Spannungssignal (372) anzulegen, und um den zweiten Anschluss der Offset-Kapazität zyklisch mit dem Ladungs-Summationsknoten (232) zu koppeln und von dem Ladungs-Summationsknoten zu trennen.

7. Kapazitätsmessschaltung (100; 300; 400) gemäß Anspruch 6, wobei der Delta-Sigma-Modulator ausgelegt ist, um an den ersten Anschluss (374a; 474a) der Offset-Kapazität ein sinusförmiges Spannungssignal (372) anzulegen, dass gegenphasig zu dem von der Messspannungsquelle (110) bereitgestellten sinusförmigen Spannungssignal (242) ist; und wobei der Delta-Sigma-Modulator ausgelegt ist, um den zweiten Anschluss (274b; 374b; 474b) der Offset-Kapazität und den zweiten Anschluss (120b; 374b; 474b) der zu messenden Kapazität während der gleichen Zeitintervalle mit dem Ladungs-Summationsknoten (232) zu verbinden.

8. Kapazitätsmessschaltung (100; 400) gemäß Anspruch 7, wobei der Delta-Sigma-Modulator ausgelegt ist, um den zweiten Anschluss (474b) der Offset-Kapazität und den zweiten Anschluss (474b) der zu messenden Kapazität über einen gemeinsamen (446) Schalter mit dem Ladungs-Summationsknoten (232) zu verbinden.

9. Kapazitätsmessschaltung gemäß einem der Ansprüche 5 bis 8, wobei der Delta-Sigma-Modulator eine Rückkopplungs-Ladungs-Bereitstellungsschaltung (482;492) aufweist, die ausgelegt ist, um eine von dem Ergebnis des Vergleichs abhängige Ladungsmenge (Qfb) zu dem Ladungs-Summationsknoten (232) zuzuführen;
wobei die Rückkopplungs-Ladungs-Bereitstellungsschaltung zumindest eine erste Rückkopplungskapazität (Cfb; Cfb-) aufweist;
wobei die Rückkopplungs-Ladungs-Bereitstellungsschaltung ausgelegt ist, um an einen ersten Anschluss (485a; 495a) der ersten Rückkopplungskapazität ein sinusförmiges Spannungssignal (484; 494a) anzulegen, und um einen zweiten Anschluss (485b; 495b) der ersten Rückkopplungskapazität in Abhängigkeit von dem Ergebnis des Vergleichs mit dem Ladungs-Summationsknoten zu koppeln oder von dem Ladungs-Summationsknoten zu trennen.

10. Kapazitätsmessschaltung gemäß Anspruch 9, wobei die Rückkopplungs-Ladungs-Bereitstellungsschaltung (492) eine zweite Rückkopplungskapazität (Cfb+) aufweist;
wobei die Rückkopplungs-Ladungs-Bereitstellungsschaltung ausgelegt ist, um an einen ersten Anschluss (495c) der zweiten Rückkopplungskapazität (Cfb+) ein sinusförmiges Spannungssignal (494b) anzulegen, das zu dem an dem ersten Anschluss (495a) der ersten Rückkopplungskapazität (Cfb-) anliegenden sinusförmigen Spannungssignal (494a) gegenphasig ist, und

um in Abhängigkeit von dem Ergebnis des Vergleich den zweiten Anschluss (495b) der ersten Rückkopplungskapazität oder einen zweiten Anschluss (495d) der zweiten Rückkopplungskapazität mit dem Ladungs-Summationsknoten zu koppeln.

11. Sensorsystem, mit folgenden Merkmalen.
einer Sensorkapazität (Cmess; Csensor), die ausgelegt ist, um einen Kapazitätswert in Abhängigkeit von einer zu messenden Größe um mindestens 20% zu verändern; und
einer Kapazitätsmessschaltung (100; 200; 300; 400)gemäß einem der Ansprüche 1 bis 10, wobei die Kapazitätsmessschaltung mit der Sensorkapazität gekoppelt ist, so dass die Sensorkapazität die zu messende Kapazität bildet.

12. Sensorsystem gemäß Anspruch 11, wobei die Kapazitätsmessschaltung ausgelegt ist, um unter der Annahme einer bekannten Amplitude des von der Messspannungsquelle (110) gelieferten sinusförmigen Spannungssignals (242) eine Auswertung durchzuführen, um eine Information zu erhalten, die einen Kapazitätswert der zu messenden Kapazität (Cmess; Csensor) beschreibt.

13. Sensorsystem gemäß Anspruch 11 oder 12, wobei die Sensorkapazität eine Eingangskapazität des Delta-Sigma-Modulators bildet.

14. Verfahren (700) zum Bestimmen eines Kapazitätswerts einer zu messenden Kapazität, mit folgenden Schritten:

Zuführen (710) eines sinusförmigen Spannungssignals zu einem ersten Anschluss der zu messenden Kapazität;
Empfangen (720) einer Ladung von einem zweiten Anschluss der zu messenden Kapazität; und
Bereitstellen (730) eines digitalen Ausgangssignals, so dass das digitale Ausgangssignal von einer Größe der von der zu messenden Kapazität erhaltenen Ladung abhängig ist;
wobei die zu messende Kapazität in einer ersten Phase unter Verwendung des sinusförmigen Spannungssignals in einen ersten Aufladungszustand gebraucht wird, und wobei die zu messende Kapazität in einer zweiten Phase unter Verwendung des sinusförmigen Spannungssignals in einen zweiten Aufladungszustand gebracht wird; und
wobei in Abhängigkeit von einer Ladungsmenge, die gleich einem Unterschied zwischen einer auf der zu messenden Kapazität (Cmess, Csensor) in dem ersten Aufladungszustand gespeicherten Ladungsmenge und einer auf der zu messenden Kapazität in dem zweiten Aufladungszustand gespeicherten Ladungsmenge ist, unter Verwendung einer Delta-Sigma-Modulation das digitale Ausgangssignal bereitgestellt wird.

## Claims

1. A capacity measuring circuit (100; 200; 300; 400) comprising:

a measuring voltage source (110) configured to feed a sinusoidal voltage signal (242) to a first terminal (120a; 244a; 444a) of a capacity to be measured (Cmess, Csensor) so as to cause a temporal change in a charge stored on the capacity to be measured; and
a delta-sigma modulator (130; 230, Csensor, 246, 250, 260, 270), the delta-sigma modulator being configured to receive a charge from a second terminal (120b; 244b; 444b) of the capacity to be measured and to provide a digital output signal (132; 252) which depends on a quantity of the charge received from the capacity to be measured; wherein the capacity measuring circuit is configured to bring the capacity to be measured (Cmess, Csensor) to a first charge state in a first phase using the sinusoidal voltage signal (242) and to bring the capacity to be measured to a second charge state in a second phase using the sinusoidal voltage signal (242); and
wherein the delta-sigma modulator (130; 230, Csensor, 246, 250, 260, 270) is configured to receive an amount of charge equaling a difference between an amount of charge stored on the capacity to be measured (Cmess, Csensor) in the first charge state and an amount of charge stored on the capacity to be measured in the second charge state and to provide the digital output signal (132; 252) in dependence on the amount of charge received.

2. The capacity measuring circuit (100; 200; 300; 400) in accordance with claim 1, wherein the delta-sigma modulator comprises an integration capacity (Cint), and
wherein the delta-sigma modulator is configured to separate the second terminal (120b; 244b; 444b) of the capacity to be measured (Cmess, Csensor) from the integration capacity in the first phase such that a charge on the integration capacity remains uninfluenced by a change in the charge stored on the capacity to be measured during the first phase; and

wherein the delta-sigma modulator is configured to couple the second terminal of the capacity to be measured to the integration capacity in the second phase such that, in the second phase, a charge on the integration capacity is influenced by a change, taking place during the second phase, of the charge stored on the capacity to be measured.

3. The capacity measuring circuit (100; 200; 300; 400) in accordance with one of claims 1 to 2, wherein the delta-sigma modulator is configured to pull the second terminal (120b; 244b; 444b) of the capacity to be measured to a predetermined constant potential (GND), except for transition phases during which the second terminal of the capacity to be measured is in an electrically floating state.

4. The capacity measuring circuit (100; 200; 300; 400) in accordance with one of claims 1 to 3, wherein the delta-sigma modulator is configured to connect the second terminal (120b, 244b; 444b) of the capacity to be measured to a reference potential feed for a reference potential (GND) in a first phase and to connect the second terminal of the capacity to be measured to a virtual mass node pulled to the reference potential in a second phase and to detect a change in the charge stored on the capacity to be measured during the second phase.

5. The capacity measuring circuit (100; 200; 300; 400) in accordance with one of claims 1 to 4, wherein the delta-sigma modulator comprises a charge integrator (230) comprising an input-side charge summation node (232) and an integration result output (233), wherein the charge integrator is configured to integrate a charge received at the input-side charge summation node so as to obtain the signal at the integration result output; wherein the delta-sigma modulator additionally comprises a threshold value comparer (250) configured to compare a level applied to the integration result output (233) of the charge integrator, which describes an integral of the charge received at the charge summation node, to a threshold value and to provide a discrete value of the digital output signal (132; 252) depending on a result of the comparison; and wherein the delta-sigma modulator is configured to receive a charge from the second terminal (120b; 244b; 444b) of the capacity to be measured (Cmess, Csensor) at the charge summation node (232) and to additionally feed an amount of charge (Qfb) depending on the result of the comparison to the charge summation node.

6. The capacity measuring circuit (100; 200; 300; 400) in accordance with claim 5, wherein the delta-sigma modulator is configured to feed a predetermined amount of charge (Qoffset) which at least partly compensates an amount of charge received from the capacity to be measured (Cmess, Csensor) to the charge summation node in a phase of the delta-sigma modulator and wherein the delta-sigma modulator comprises an offset capacity (Coffset; Coff) comprising a first terminal (274a; 374; 474a) and a second terminal (274b; 374b; 474b), the delta-sigma modulator being configured to apply a sinusoidal voltage signal (372) to the first terminal of the offset capacity and to cyclically couple and separate the second terminal of the offset capacity to and from the charge summation node (232), respectively.

7. The capacity measuring circuit (100, 300; 400) in accordance with claim 6, wherein the delta-sigma modulator is configured to apply to the first terminal (374a; 474a) of the offset capacity a sinusoidal voltage signal (372) which is opposite in phase compared to the sinusoidal voltage signal (242) provided by the measuring voltage source (110); and wherein the delta-sigma modulator is configured to connect the second terminal (274b; 374b, 474b) of the offset capacity and the second terminal (120b; 374b; 474b) of the capacity to be measured to the charge summation node (232) during the same time intervals.

8. The capacity measuring circuit (100; 400) in accordance with claim 7, wherein the delta-sigma modulator is configured to connect the second terminal (474b) of the offset capacity and the second terminal (474b) of the capacity to be measured to the charge summation node (232) via a common switch (446).

9. The capacity measuring circuit in accordance with one of claims 5 to 8, wherein the delta-sigma modulator comprises a feedback charge providing circuit (482; 492) configured to feed an amount of charge (Qfb) depending on the result of the comparison to the charge summation node (232); wherein the feedback charge providing circuit comprises at least a first feedback capacity (Cfb; Cfb-); wherein the feedback charge providing circuit is configured to apply a sinusoidal voltage signal (484; 494a) to a first terminal (485a; 495a) of the first feedback capacity and to couple or separate a second terminal (485b; 495b) of the first feedback capacity to and from the charge summation node, respectively, in dependence on the result of the comparison.

10. The capacity measuring circuit in accordance with claim 9, wherein the feedback charge providing circuit (492) comprises a second feedback capacity (Cfb+); wherein the feedback charge providing circuit is configured to apply to a first terminal (495c) of the second feedback capacity (Cfb+) a sinusoidal voltage signal (494b) which is opposite in phase compared to the sinusoidal voltage signal (494a) applied to the first terminal (495a) of the first feedback capacity (Cfb-), and

to couple, depending on the result of the comparison, either the second terminal (495b) of the first feedback capacity or a second terminal (495d) of the second feedback capacity to the charge summation node.

11. A sensor system comprising:

a sensor capacity (Cmess; Csensor) configured to change a capacity value by at least 20% in dependence on a quantity to be measured; and a capacity measuring circuit (100; 200; 300; 400) in accordance with one of claims 1 to 10, wherein the capacity measuring circuit is coupled to the sensor capacity such that the sensor capacity represents the capacity to be measured.

12. The sensor system in accordance with claim 11, wherein the capacity measuring circuit is configured to effect, assuming the amplitude of the sinusoidal voltage signal (242) provided by the measuring voltage source (110) is known, an evaluation so as to obtain a piece of information describing a capacity value of the capacity to be measured (Cmess; Csensor).

13. The sensor system in accordance with claim 11 or 12, wherein the sensor capacity represents an input capacity of the delta-sigma modulator.

14. A method (700) for determining a capacity value of a capacity to be measured, comprising:

feeding (710) a sinusoidal voltage signal to a first terminal of the capacity to be measured; receiving (720) a charge from a second terminal of the capacity to be measured; and proving (730) a digital output signal such that the digital output signal is dependent on a quantity of the charge received from the capacity to be measured; wherein the capacity to be measured is placed in a first charge state using the sinusoidal voltage signal in a first phase, and wherein the capacity to be measured is placed in a second charge state using the sinusoidal voltage signal in a second phase; and wherein the digital output signal is provided using a delta-sigma modulation, in dependence on an amount of charge equaling a difference between an amount of charge stored on the capacity to be measured (Cmess, Csensor) in the first charge state and an amount of charge stored on the capacity to be measured in the second charge state.

**Revendications**

1. Circuit de mesure de capacité (100; 200; 300; 400) aux caractéristiques suivantes:

une source de tension de mesure (110) conçue pour alimenter un signal de tension sinusoïdale (242) à une première connexion (120a; 244a; 444a) d'une capacité à mesurer (Cmess, Csensor), pour provoquer une variation temporelle d'une charge accumulée dans la capacité à mesurer; et
un modulateur delta-sigma (130; 230, Csensor, 246, 250, 260, 270), le modulateur delta-sigma étant conçu pour obtenir une charge d'une deuxième connexion (120b; 244b; 444b) de la capacité à mesurer et pour mettre à disposition un signal de sortie numérique (132; 252) qui est fonction d'une grandeur de la charge obtenue de la capacité à mesurer;
dans lequel ledit circuit de mesure de capacité est conçu pour amener la capacité à mesurer (Cmess, Csensor), dans une première phase, à l'aide du signal de tension sinusoïdale (242) en un premier état de charge et pour amener la capacité à mesurer, dans une deuxième phase, à l'aide du signal de tension sinusoïdale (242) en un deuxième état de charge; et
dans lequel le modulateur delta-sigma (130; 230, Csensor, 246, 250, 260, 270) est conçu pour recevoir une quantité de charge égale à une différence entre une quantité de charge accumulée, dans le premier état de charge, sur la capacité à mesurer (Cmess, Csensor) et une quantité de charge accumulée, dans le deuxième état de charge, sur la capacité à mesurer et pour mettre à disposition le signal de sortie numérique (132; 252) en fonction de la quantité de charge reçue.

2. Circuit de mesure de capacité (100; 200; 300; 400) selon la revendication 1, dans lequel le modulateur delta-sigma présente une capacité d'intégration (Cint), et

dans lequel le modulateur delta-sigma est conçu pour séparer la deuxième connexion (120b; 244b; 444b) de la capacité à mesurer (Cmess, Csensor), dans la première phase, de la capacité d'intégration, de sorte qu'une charge sur la capacité d'intégration reste non influencée par une variation de la charge accumulée sur la capacité à mesurer pendant la première phase; et
dans lequel le modulateur delta-sigma est conçu pour coupler la deuxième connexion de la capacité à mesurer, dans la deuxième phase, à la capacité d'intégration, de sorte qu'une charge sur la capacité d'intégration dans la deuxième phase soit influencée par une variation se produisant pendant la deuxième phase de la charge accumulée sur la capacité à mesurer.

3. Circuit de mesure de capacité (100; 200; 300; 400) selon l'une des revendications 1 à 2, dans lequel le modulateur delta-sigma est conçu pour amener la deuxième connexion (120b; 244b; 444b) de la capacité à mesurer, en dehors des phases de transition pendant lesquelles la deuxième connexion de la capacité à mesurer se trouve dans un état flottant électriquement, à un potentiel constant prédéterminé (GND).

4. Circuit de mesure de capacité (100; 200; 300; 400) selon l'une des revendications 1 à 3, dans lequel le modulateur delta-sigma est conçu pour connecter la deuxième connexion (120b; 244b; 444b) de la capacité à mesurer, dans une première phase, à une alimentation de potentiel de référence pour un potentiel de référence (GND) et pour connecter la deuxième connexion de la capacité à mesurer, dans une deuxième phase, à un noeud de masse virtuelle qui est amené au potentiel de référence et pour détecter une variation de la charge accumulée sur la capacité à mesurer pendant la deuxième phase.

5. Circuit de mesure de capacité (100; 200; 300; 400) selon l'une des revendications 1 à 4, dans lequel le modulateur delta-sigma présente un intégrateur de charge (230) avec un noeud d'addition de charge du côté de l'entrée (232) et une sortie de résultat d'intégration (233), dans lequel l'intégrateur de charge est conçu pour intégrer une charge reçue au noeud d'addition de charge du côté de l'entrée, pour obtenir le signal à la sortie de résultat d'intégration;
dans lequel le modulateur delta-sigma présente par ailleurs un comparateur de valeur de seuil (250) conçu pour comparer un niveau présent à la sortie de résultat d'intégration (233) de l'intégrateur de charge qui décrit une intégrale de la charge reçue au noeud d'addition de charge avec une valeur de seuil et pour mettre à disposition, en fonction d'un résultat de la comparaison, une valeur discrète du signal de sortie numérique (132; 252); et
dans lequel le modulateur delta-sigma est conçu pour recevoir, au noeud d'addition de charge (232), une charge de la deuxième connexion (120b; 244b; 444b) de la capacité à mesurer (Cmess, Csensor) et pour alimenter en outre une quantité de charge (Qfb) fonction du résultat de la comparaison vers le noeud d'addition de charge.

6. Circuit de mesure de capacité (100; 200; 300; 400) selon la revendication 5, dans lequel le modulateur delta-sigma est conçu pour alimenter vers le noeud d'addition de charge, dans une phase du modulateur delta-sigma, une quantité de charge prédéterminée (Qoffset) qui compense au moins partiellement une quantité de charge reçue de la capacité à mesurer (Cmess; Csensor), et dans lequel le modulateur delta-sigma présente une capacité de décalage (Coffset; Coff) avec une première connexion (274a; 374; 474a) et une deuxième connexion (274b; 374b; 474b), dans lequel le modulateur delta-sigma est conçu pour appliquer à la première connexion de la capacité de décalage un signal de tension sinusoïdale (372) et pour coupler la deuxième connexion de la capacité de décalage cycliquement avec le noeud d'addition de charge (232) et le séparer cycliquement du noeud d'addition de charge.

7. Circuit de mesure de capacité (100; 300; 400) selon la revendication 6, dans lequel le modulateur delta-sigma est conçu pour appliquer à la première connexion (374a; 474a) de la capacité de décalage un signal de tension sinusoïdale (372) qui est de phase opposée au signal de tension sinusoïdale (242) mis à disposition par la source de tension de mesure (110); et
dans lequel le modulateur delta-sigma est conçu pour connecter la deuxième connexion (274b; 374b; 474b) de la capacité de décalage et la deuxième connexion (120b; 374b; 474b) de la capacité à mesurer pendant les mêmes intervalles de temps au noeud d'addition de charge (232).

8. Circuit de mesure de capacité (100; 400) selon la revendication 7, dans lequel le modulateur delta-sigma est conçu pour connecter la deuxième connexion (474b) de la capacité de décalage et la deuxième connexion (474b) de la capacité à mesurer par l'intermédiaire d'un interrupteur commun (446) au noeud d'addition de charge (232).

9. Circuit de mesure de capacité selon l'une des revendications 5 à 8, dans lequel ledit modulateur delta-sigma présente un circuit de mise à disposition de charge à couplage rétroactif (482; 492) qui est conçu pour alimenter une quantité de charge (Qfb) fonction du résultat de la comparaison au noeud d'addition de charge (232);
dans lequel le circuit de mise à disposition de charge à couplage rétroactif présente au moins une première capacité de couplage rétroactif (Cfb; Cfb-);
dans lequel le circuit de mise à disposition de charge à couplage rétroactif est conçu pour appliquer à une première connexion (485a; 495a) de la première capacité de couplage rétroactif un signal de tension sinusoïdale (484; 494a), et pour coupler une deuxième connexion (485b; 495b) de la première capacité de couplage rétroactif en fonction du résultat de la comparaison au noeud d'addition de charge ou pour la séparer du noeud d'addition de charge.

**10.** Circuit de mesure de capacité selon la revendication 9, dans lequel le circuit de mise à disposition de charge à couplage rétroactif (492) présente une deuxième capacité de couplage rétroactif (Cfb+);

dans lequel le circuit de mise à disposition de charge à couplage rétroactif est conçu pour appliquer à une première connexion (495c) de la deuxième capacité de couplage rétroactif (Cfb+) un signal de tension sinusoïdale (494b) qui est opposé en phase au signal de tension sinusoïdale (494a) présent à la première connexion (495a) de la première capacité de couplage rétroactif (Cfb-), et

et pour coupler, en fonction du résultat de la comparaison, la deuxième connexion (495b) de la première capacité de couplage rétroactif ou une deuxième connexion (495d) de la deuxième capacité de couplage rétroactif au noeud d'addition de charge.

**11.** Système de capteur, aux caractéristiques suivantes:

une capacité de capteur (Cmess; Csensor) qui est conçue pour faire varier d'au moins 20% une valeur de capacité en fonction d'une grandeur à mesurer; et

un circuit de mesure de capacité (100; 200; 300; 400) selon l'une des revendications 1 à 10, dans lequel le circuit de mesure de capacité est couplé à la capacité de capteur, de sorte que la capacité de capteur constitue la capacité à mesurer.

**12.** Système de capteur selon la revendication 11, dans lequel le circuit de mesure de capacité est conçu pour effectuer, en supposant une amplitude connue du signal de tension sinusoïdale (242) fourni par la source de tension de mesure (110), une évaluation pour obtenir une information décrivant une valeur de capacité de la capacité à mesurer (Cmess; Csensor).

**13.** Système de capteur selon la revendication 11 ou 12, dans lequel le capteur de capacité constitue une capacité d'entrée du modulateur delta-sigma.

**14.** Procédé (700) pour déterminer une valeur de capacité d'une capacité à mesurer, aux étapes suivantes consistant à:

alimenter (710) un signal de tension sinusoïdale vers une première connexion de la capacité à mesurer;

recevoir (720) une charge d'une deuxième connexion de la capacité à mesurer; et

mettre à disposition (730) un signal de sortie numérique, de sorte que le signal de sortie numérique soit fonction d'une grandeur de la charge obtenue de la capacité à mesurer;

dans lequel la capacité à mesurer est amenée, dans une première phase, à l'aide du signal de tension sinusoïdale en un premier état de charge, et la capacité à mesurer est amenée, dans une deuxième phase, à l'aide du signal de tension sinusoïdale en un deuxième état de charge; et

dans lequel le signal de sortie numérique est mis à disposition à l'aide d'une modulation delta-sigma en fonction d'une quantité de charge égale à une différence entre une quantité de charge accumulée sur la capacité à mesurer (Cmess, Csensor) dans le premier état de charge et une quantité de charge accumulée sur la capacité à mesurer dans le deuxième état de charge.

**FIG 1**

Kapazitive Messschaltung mittels "Standard"-Sigma-Delta Modulator

vrefp = positive Referenzspannung,  vrefn = negative Referenzspannung

FIG 2

EP 2 603 977 B1

Kapazitive Messschaltung mittels "Sinus"-Sigma-Delta Modulator

vrefp=positive Referenzspannung, vrefn=negative Referenzspannung

FIG 3

EP 2 603 977 B1

Kapazitive Messschaltung mittels "Sinus"-Sigma-Delta Modulator

vrefp=positive Referenzspannung, vrefn=negative Referenzspannung

FIG 4A

EP 2 603 977 B1

Kapazitive Messschaltung mittels "Sinus"-Sigma-Delta Modulator

480

482
Sinus
484
$C_{fb}$
485a  485b
$S_{1/2}$
486
GND
$S_{1/2fb}$
487
GND

440
-Sinus
372
$C_{off}$
474a  474b
+Sinus
242
$C_{sensor}$
444a  444b
$S_{1/2}$
446
GND

252
230
$C_{int}$
234
232
GND
250
GND
Dig. Bitstrom
252

FIG 4B

Kapazitive Messschaltung mittels "Sinus"-Sigma-Delta Modulator

FIG 4C

EP 2 603 977 B1

Takt Schema für "Sinus"-Sigma-Delta Modulator

$S_{1/2}$:1=Phase 1, 2=Phase 2, nichtüberlappender Takt

FIG 5

EP 2 603 977 B1

610

C (zum Beispiel C_fb oder C_offset)

$S_1$   644a   644b   $S_2$

622   $S_2$   $S_1$   628

624   626

GND   GND

$S_{1/2}$:1=Phase 1, 2=Phase 2, nichtüberlappender Takt

630

640  Takt 1

Takt 2

aktiv

inaktiv

aktiv

inaktiv

Zyklus

$t_1$  $t_{11}$   $t_2$  $t_{21}$   $t_3$

FIG 6A

EP 2 603 977 B1

EP 2 603 977 B1

FIG 6B

700

| Zuführen eines sinusförmigen Spannungssignals zu einem ersten Anschluss der zu messenden Kapazität; | 710 |

| Empfangen einer Ladung von einem zweiten Anschluss der zu messenden Kapazität; und | 720 |

| Bereitstellen eines digitalen Ausgangssignals, so dass das digitale Ausgangssignal von einer Größe der von der zu messenden Kapazität erhaltenen Ladung abhängig ist. | 730 |

# FIG 7

FIG 8

EP 2 603 977 B1

FIG 9

vrefp = positive Referenzspannung, vrefn = negative Referenzspannung

Kapazitive Messschaltung mittels "Standard"-Sigma-Delta Modulator

vrefp = positive Referenzspannung, vrefn = negative Referenzspannung

FIG 10

EP 2 603 977 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102005038875 A1

- WO 2006098976 A2

**In der Beschreibung aufgeführte Nicht-Patentliteratur**

- Force feedback linearization for higher-order electro-mechanical sigma-delta modulators. **Y. DONG U.A.** Journal of Micromechanics and Microengineering. Institute of Physics Publishing, 01. Juni 2006, vol. 16, S54-S60

- **C. ZHANG.** A large dynamic range CMOS Readout Circuit for MEMS Vibratory Gyroscope. *IEEE Sensors 2008 Conference,* 26. Oktober 2008, 1123-1126